(19) Europäisches Patentamt
European Patent Office
Office européen des brevets

(11) EP 3 223 026 B1

(12) EUROPÄISCHE PATENTSCHRIFT

(45) Veröffentlichungstag und Bekanntmachung des Hinweises auf die Patenterteilung:
28.04.2021 Patentblatt 2021/17

(51) Int Cl.:
*G01R 31/08* (2020.01)

(21) Anmeldenummer: **16161729.5**

(22) Anmeldetag: **22.03.2016**

(54) **VERFAHREN, EINRICHTUNG UND SYSTEM ZUM ERMITTELN DES FEHLERORTES EINES FEHLERS AUF EINER LEITUNG EINES ELEKTRISCHEN ENERGIEVERSORGUNGSNETZES**

METHOD, DEVICE AND SYSTEM FOR DETERMINING THE LOCATION A FAULT ON A LINE OF AN ELECTRICAL ENERGY SUPPLY NETWORK

PROCÉDÉ, DISPOSITIF ET SYSTÈME DESTINES À LOCALISER UN DÉFAUT SUR UNE LIGNE D'UN RÉSEAU D'ALIMENTATION ÉLECTRIQUE

(84) Benannte Vertragsstaaten:
AL AT BE BG CH CY CZ DE DK EE ES FI FR GB GR HR HU IE IS IT LI LT LU LV MC MK MT NL NO PL PT RO RS SE SI SK SM TR

(43) Veröffentlichungstag der Anmeldung:
27.09.2017 Patentblatt 2017/39

(73) Patentinhaber: **Siemens Aktiengesellschaft**
**80333 München (DE)**

(72) Erfinder:
• **Dzienis, Cezary**
**14624 Dallgow-Döberitz (DE)**
• **Jurisch, Andreas**
**16727 Schwante (DE)**

(56) Entgegenhaltungen:
US-A1- 2006 012 374    US-A1- 2013 096 854
US-A1- 2015 081 236

• **EVRENOSOGLU C Y ET AL: "Bewley Diagrams Revisited via Visualization", IEEE TRANSACTIONS ON POWER SYSTEMS, IEEE SERVICE CENTER, PISCATAWAY, NJ, US, Bd. 24, Nr. 3, 1. August 2009 (2009-08-01) , Seiten 1401-1407, XP011270276, ISSN: 0885-8950, DOI: 10.1109/TPWRS.2009.2022579**
• **LI XIAQING ET AL: "Operating state monitoring and fault diagnosis on traction power supply system", INDUSTRIAL ELECTRONICS AND APPLICATIONS, 2008. ICIEA 2008. 3RD IEEE CONFERENCE ON, IEEE, PISCATAWAY, NJ, USA, 3. Juni 2008 (2008-06-03), Seiten 866-870, XP031293847, ISBN: 978-1-4244-1717-9**
• **SEPEHR SEFIDPOUR ET AL: "Factors affecting traveling wave protection", ADVANCED POWER SYSTEM AUTOMATION AND PROTECTION (APAP), 2011 INTERNATIONAL CONFERENCE ON, IEEE, 16. Oktober 2011 (2011-10-16), Seiten 1359-1365, XP032162526, DOI: 10.1109/APAP.2011.6180590 ISBN: 978-1-4244-9622-8**

EP 3 223 026 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Ermitteln des Fehlerortes eines Fehlers auf einer Leitung eines elektrischen Energieversorgungsnetzes, bei dem an einem ersten Leitungsende der Leitung erste Strom- und/oder Spannungswerte gemessen und mit einem Zeitstempel versehen werden, an einem zweiten Leitungsende der Leitung zweite Strom- und/oder Spannungswerte gemessen und mit einem Zeitstempel versehen werden, und unter Verwendung der zeitgestempelten ersten und zweiten Strom- und/oder Spannungswerte nach dem Auftreten eines Fehlers auf der Leitung dessen Fehlerort bestimmt wird.

Die Erfindung betrifft auch eine entsprechende Einrichtung sowie ein System zum Ermitteln des Fehlerortes eines Fehlers auf einer Leitung eines elektrischen Energieversorgungsnetzes.

Ein solches Verfahren sowie eine solche Einrichtung zum Ermitteln eines Fehlerortes sind beispielsweise aus der US 2006/0012374 A1 bekannt.

Der sichere Betrieb elektrischer Energieversorgungsnetze erfordert die schnelle und zuverlässige Erkennung und Abschaltung etwaiger Fehler, wie z.B. Kurzschlüssen oder Erdschlüssen. Fehlerursachen, die eine Abschaltung bewirken, können beispielsweise Blitzeinschläge, gerissene oder anderweitig schadhafte Leitungen, fehlerhafte Isolierungen bei Kabelleitungen oder die ungewollte Berührung von Freileitungen mit Tier- oder Pflanzenteilen sein. Zur Verkürzung von fehlerbedingten Ausfallzeiten müssen solche Fehler möglichst genau lokalisiert werden, um eine Behebung der Fehlerursache und etwaiger durch den Fehler herbeigeführter Folgeschäden durch ein Wartungsteam zu ermöglichen.

Im einfachsten, aber auch aufwendigsten, Fall findet eine Fehlerortung durch Inaugenscheinnahme statt. Dabei fährt das Wartungsteam die fehlerhafte Leitung ab und untersucht sie auf sichtbare Fehlerstellen. Diese Vorgehensweise ist langsam und fehleranfällig.

Daher ist man weitgehend dazu übergegangen, den Fehlerort, an dem sich der Fehler auf der Leitung befindet, mittels einer Analyse von während des Fehlereintritts erfassten Messgrößen, z.B. Strömen und Spannungen, einzugrenzen. Hierfür sind mittlerweile mehrere unterschiedliche Verfahren bekannt, deren Genauigkeit sich signifikant auf den Wartungsaufwand des Energieversorgungsnetzes auswirkt. Daher wird großer Wert darauf gelegt, die Genauigkeit der für die Fehlerortung eingesetzten Algorithmen zu verbessern, um die Wartung zu erleichtern und insbesondere fehlerbedingte Ausfallzeiten des Energieversorgungsnetzes zu verkürzen.

Ein grobes Ergebnis des Fehlerortes lässt sich beispielsweise durch die Feststellung der Fehlerrichtung erreichen. Diese Methode wird überwiegend in gelöschten, isolierten sowie hochohmig geerdeten Energieversorgungsnetzen mit einer radialen Struktur bzw. einem geringen Vermaschungsgrad eingesetzt. Dabei kann beispielsweise eine wattmetrische Methode verwendet werden, wie sie aus dem Europäischen Patent EP 2476002 B1 bekannt ist. Eine andere Methode zur Erkennung der Fehlerrichtung ist das sogenannte "Wischerrelais-Prinzip", das in einer möglichen ausführungsform beispielsweise aus der internationalen Patentanmeldung WO 2012126526 A1 hervorgeht. Zur genaueren Fehlerortung ist bei diesen Methoden allerdings eine zusätzliche Auswertung nötig.

Verfahren zur genaueren Fehlerortung verwenden beispielsweise die gemessenen Strom- bzw. Spannungssignale der Grundwelle (50Hz- bzw. 60Hz-Signale) zur Fehlerortung. Hierbei sind Verfahren bekannt, die Messwerte von nur einem der Leitungsenden (einseitige Fehlerortung) oder Messwerte von beiden Leitungsenden (zweiseitige Fehlerortung) verwenden. Als Ergebnis wird der Fehlerort in der Regel als Entfernung von der jeweiligen Messstelle (in Prozent der Leitung oder in km bzw. Meilen) angegeben.

Im Fall der Verwendung von Messwerten nur eines Leitungsendes ist der Aufwand zur Durchführung der Fehlerortung gering. Bei dieser Fehlerortungsmethode handelt es sich überwiegend um eine impedanzbasierte Methode, bei der aus Strom- und Spannungsmesswerten eine Impedanz bis zum Fehlerort berechnet wird. Durch Vergleich mit der Leitungsimpedanz der gesamten Leitung im fehlerfreien Fall lässt sich ein Rückschluss auf den Fehlerort ziehen. Eine beispielhafte Ausführung eines solchen Fehlerortungsverfahrens kann beispielsweise der US-Patentschrift US 4996624 A entnommen werden.

Die Genauigkeit dieser Methode hängt unter anderem stark von der Messgenauigkeit der verwendeten Strom- und Spannungswandler, der Genauigkeit der zur Fehlerortung verwendeten Leitungsparameter (z.B. Impedanzbelag) sowie von den gegebenen Fehlerbedingungen (z.B. Fehlerwiderstand, Last) und der Netzbeschaffenheit ab. Störungen und die Einschwingvorgänge in den Strom- und Spannungssignalen können sich negativ auf die Genauigkeit dieser Methode auswirken. Die dadurch entstehenden Messfehler können mehrere Prozent betragen.

Eine verbesserte Genauigkeit bei der Fehlerortung lässt sich durch die Verwendung von Messwerten von beiden Leitungsenden erreichen. Hierbei müssen die fehlerortungsbezogenen Messwerte über eine geeignete Kommunikationsverbindung zusammengeführt werden. In diesem Zusammenhang sei auf die US-Patentschrift US 5,929,642 verwiesen; bei dem dort beschriebenen Verfahren wird unter Verwendung von Strom- und Spannungsmesswerten von beiden Leitungsenden mithilfe von Schätzverfahren und nichtlinearen Optimierungsverfahren eine recht hohe Genauigkeit (Messfehler ca. 1-2%) bei der Fehlerortung erreicht.

Während die Genauigkeit der Fehlerortung bei den impedanzbasierten Fehlerortungsverfahren von der Messgenauigkeit der verwendeten Messwandler sowie der Netzbeschaffenheit abhängt, lässt sich durch die Verwendung eines Fehlerortungsverfahrens nach dem sogenannten Wanderwellen-Prinzip ("Traveling Wave Fault Location") eine weitgehende Unabhängigkeit von diesen Größen erreichen. Nach diesem Prinzip werden anstelle der Grundwellen der gemessenen Strom- und Spannungssignale die beim Fehler entstehenden transienten Signalanteile, die in Form von sogenannten "Wanderwellen" auftreten, zur Fehlerortung in Betracht gezogen. Hierbei werden die hochfrequenten Wanderwellen-Flanken messtechnisch erfasst und mit einem Zeitstempel versehen. Da die Propagationsgeschwindigkeit der Wanderwellen etwa bei der Lichtgeschwindigkeit liegt, lässt sich aus der Auswertung der Zeitstempelung die Ortung des Fehlers gut durchführen. Mit diesem Fehlerortungsverfahren können Genauigkeiten im Bereich von wenigen Dutzend Metern erreicht werden. Ein Beispiel eines solchen Fehlerortungsverfahrens kann der US-Patentschrift US 8,655,609 B2 entnommen werden.

Ausgehend von einem Verfahren und einer Einrichtung der eingangs angegebenen Art liegt der Erfindung die Aufgabe zugrunde, eine Fehlerortung mit Messwerten von beiden Leitungsenden mit noch höherer Genauigkeit durchführen zu können.

Diese Aufgabe wird erfindungsgemäß durch ein Verfahren der eingangs angegebenen Art gelöst, bei dem unter Verwendung der zeitgestempelten ersten und zweiten Strom- und/oder Spannungswerte an beiden Leitungsenden Profile von beim Auftreten des Fehlers sich entlang der Leitung in Richtung der Leitungsenden ausbreitenden Wanderwellen ermittelt werden, und der Fehlerort aus den für beide Leitungsenden ermittelten Profilen der Wanderwellen bestimmt wird, indem eine Zeitdifferenz bestimmt wird, mit der die Wanderwellen an den beiden Leitungsenden eintreffen, wobei die Zeitdifferenz aus einem Mustervergleich der für die Leitungsenden ermittelten Profile der Wanderwellen bestimmt wird.

Dadurch dass die Fehlerortung nicht allein auf der Flankenbestimmung der Wanderwellen beruht, sondern ein Profil der Wanderwellen, und damit ein längerer Verlauf von Messwerten, berücksichtigt wird, kann die Zeitdifferenz, mit der die Wanderwellen an beiden Leitungsenden eintreffen, mit vergleichsweise hoher Genauigkeit festgelegt werden. Aus der Zeitdifferenz lässt sich in einfacher Weise auf den Fehlerort schließen.

Die zur Zeitstempelung der Strom- und/oder Spannungsmesswerte an beiden Leitungsenden verwendeten Zeitgeber (z.B. interne Uhren von Messeinrichtungen) werden bei dem erfindungsgemäßen Verfahren zeitlich miteinander synchronisiert, so dass die an beiden Leitungsenden vergebenen Zeitstempel miteinander vergleichbar sind.

Gemäß einer vorteilhaften Ausführungsform des erfindungsgemäßen Verfahrens kann vorgesehen sein, dass zum Mustervergleich der Profile der Wanderwellen eine Kreuzkorrelation der Profile durchgeführt wird. Alternativ oder zusätzlich dazu kann auch vorgesehen sein, dass zum Mustervergleich ein Winkel des Kreuzleistungsspektrums der Profile der Wanderwellen herangezogen wird.

Unter Verwendung der Kreuzkorrelation kann ein Maximum der Übereinstimmung der Profile der Wanderwellen gefunden werden. Die Verwendung des Winkels des Kreuzleistungsspektrums kann als zusätzliches oder eigenständiges Kriterium verwendet werden.

Alternativ kann gemäß einer anderen vorteilhaften Ausführungsform des erfindungsgemäßen Verfahrens auch vorgesehen sein, dass zum Mustervergleich eine Minimierung einer aus der Differenz der Profile der Wanderwellen gebildeten Zielfunktion durchgeführt wird.

Auch mit dieser Vorgehensweise kann die bestmögliche Überdeckung der Profile der Wanderwellen der beiden Leitungsenden gefunden werden, um daraus auf die Zeitdifferenz des Eintreffens der Wanderwellen zu schließen.

Gemäß einer weiteren vorteilhaften Ausführungsform des erfindungsgemäßen Verfahrens kann vorgesehen sein, dass vor dem Mustervergleich eine Korrektur des Profils der Wanderwelle zumindest eines Leitungsendes durchgeführt wird, bei der eine Dämpfung der Leitung berücksichtigt wird.

Hierdurch kann in vorteilhafter Weise eine Fehlerortung auch bei solchen Leitungen mit hoher Genauigkeit durchgeführt werden, bei denen aufgrund ihrer Länge und/oder Materialeigenschaften Verluste hinsichtlich der Messwerte nicht vernachlässigt werden können.

Eine weitere vorteilhafte Ausführungsform des erfindungsgemäßen Verfahrens sieht zudem vor, dass der Fehlerort ausschließlich unter Verwendung solcher Strom- und Spannungswerte bestimmt wird, die an den beiden Leitungsenden während des Auftretens eines ersten Wellenimpulses einer Wanderwelle gemessen worden sind.

Hierdurch kann die Menge an zu übertragenden Messwerten signifikant reduziert werden, da nicht vollständige Fehlerschriebe, sondern nur die Messwertverläufe während des ersten Impulses der Wanderwelle übertragen werden müssen. Als erster Impuls einer Wanderwelle wird in diesem Zusammenhang beispielsweise ein erster einzelner Wellenberg, ein erstes einzelnes Wellental oder die Kombination aus einem ersten Wellenberg und einem ersten Wellental angesehen. Ein weiterer Vorteil dieser Betrachtungsweise ist, dass der erste Wellenimpuls noch nicht durch Reflexionseffekte vom anderen Leitungsende überlagert ist und die Berechnung des Profils der Wanderwelle damit vergleichsweise einfacher erfolgen kann. Eine Reduzierung der zu übertragenden Messwerte ist insbesondere dann von Vorteil, wenn eine Fehlerortung in Echtzeit (Online-Fehlerortung) erfolgen soll, während bei einer nachträglichen Fehlerortung (Offline-Fehlerortung) meist mehr Zeit für die Fehlerortung zur Verfügung steht und für die Messwertübertragung eine längere Zeitdauer akzeptiert werden kann.

Zur weiteren Reduzierung der zu übertragenden Messwerte wird es zudem als vorteilhaft angesehen, wenn der Fehlerort ausschließlich unter Verwendung entweder solcher Stromwerte oder solcher Spannungswerte bestimmt wird, die an den beiden Leitungsenden während des Auftretens eines ersten Wellenimpulses einer Wanderwelle gemessen worden sind.

Dieser Ausführungsform des erfindungsgemäßen Verfahrens liegt die Erkenntnis zugrunde, dass eine Fehlerortung meist auch dann noch mit relativ hoher Genauigkeit möglich ist, wenn ausschließlich Strom- oder Spannungsmesswerte für die Bestimmung der Profile der Wanderwellen verwendet werden.

Gemäß einer weiteren vorteilhaften Ausführungsform des erfindungsgemäßen Verfahrens ist vorgesehen, dass die an den Leitungsenden gemessenen Strom- und Spannungswerte einer Filterung unterzogen werden, wobei erste und zweite gefilterte Strom- und Spannungswerte gebildet werden, die einen ausgewählten Frequenzbereich der gemessenen Strom- und Spannungswerte angeben, und die Profile der Wanderwellen unter Verwendung der ersten und zweiten gefilterten Strom- und Spannungswerte bestimmt werden.

Hierdurch können in vorteilhafter Weise nur die für die Wanderwellen relevanten Signalanteile ermittelt und zur Fehlerortung verwendet werden. Bei dieser Ausführungsform werden nämlich entsprechend der Filterauslegung nur ausgewählte Signalanteile der Strom- und Spannungsmesswerte in einem geeigneten Frequenzbereich zur Fehlerortung herangezogen.

Konkret kann diesbezüglich vorgesehen sein, dass der ausgewählte Frequenzbereich hochfrequente transiente Anteile oder bandbegrenzte transiente Anteile der gemessenen Strom- und Spannungswerte umfasst.

Außerdem kann in diesem Zusammenhang vorgesehen sein, dass die Filtercharakteristik des zur Filterung der Strom- und Spannungswerte benutzten Filters solche Frequenzbereiche bedämpft, in denen zur Messung der Strom- und Spannungsmesswerte verwendete Strom- bzw. Spannungswandler Messfehler aufweisen.

Auf diese Weise können Messfehler, die auf die Strom- bzw. Spannungswandler zurückgehen, besonders effektiv unterdrückt werden.

In diesem Zusammenhang kann zudem vorgesehen sein, dass bei einem mehrphasigen elektrischen Energieversorgungsnetz hinsichtlich der ersten und zweiten gefilterten Strom- und Spannungswerte eine mathematische Transformation zur Entkopplung der einzelnen Phasenanteile durchgeführt wird, wobei erste und zweite transformierte Strom- und Spannungswerte gebildet werden, und die Profile der Wanderwellen unter Verwendung der ersten und zweiten transformierten Strom- und Spannungswerte bestimmt werden.

Hierdurch kann das erfindungsgemäße Verfahren vorteilhaft bei - üblicherweise vorliegenden - mehrphasigen Energieversorgungsnetzen eingesetzt werden. Durch die mathematische Transformation werden die Messwerte der einzelnen Phasen entkoppelt und können einfacher ausgewertet werden. Zur Transformation kommen beispielsweise eine modale Transformation wie die Clarke-Transformation oder eine Eigenwerttransformation in Betracht.

Eine weitere vorteilhafte Ausführungsform des Erfindungsgemäßen Verfahrens sieht zudem vor, dass die Ermittlung des Fehlerortes dann vorgenommen wird, wenn im Verlauf der der ersten Strom- und Spannungswerte oder davon abgeleiteten Werten und/oder im Verlauf der zweiten Strom- und Spannungswerte oder davon abgeleiteten Werten ein Sprung festgestellt worden ist, der eine vorgegebene Schwelle übersteigt.

Auf diese Weise wird das Fehlerortungsverfahren nur bei einer sprunghaften Verlaufsänderung, wie z.B. in einem tatsächlich vorliegendem Fehlerfall, durchgeführt, weil der mit dem Fehler üblicherweise verbundene Sprung im Verlauf der Strom- und Spannungsmesswerte oder den davon abgeleiteten Werten (z.B. die oben genannten gefilterten oder transformierten Strom- und Spannungswerte) die Ausführung des Fehlerortungsverfahrens auslöst. Außerdem dient die Sprungerkennung zur korrekten Positionierung des Messfensters für die Auswertung zur Ermittlung des Fehlerortes.

Um in diesem Zusammenhang eine Unterscheidung eines tatsächlich auf der Leitung aufgetretenen Fehlerfalls von anderen Ereignissen, die sprunghafte Verlaufsänderungen bewirken, durchführen zu können, wird die mit dem Fehlerortungsverfahren ermittelte Fehlerentfernung x ausgewertet. Liegt diese Entfernung innerhalb der Leitungslänge, typisch also zwischen 0 und 1, dann ist ein Fehlerfall auf der zu überwachenden Leitung vorhanden; liegt sie hingegen außerhalb der Leitung, ist kein Fehler auf der Leitung anzunehmen.

Eine weitere vorteilhafte Ausführungsform des erfindungsgemäßen Verfahrens sieht zudem vor, dass mittels je einer Einrichtung an jedem der Leitungsenden die Ermittlung des Fehlerortes erfolgt, und die mit den Einrichtungen ermittelten Fehlerorte von den Einrichtungen ausgegeben werden.

Hierbei wird die Fehlerortermittlung an beiden Leitungsenden, zwar auf Basis derselben Messwerte, aber dennoch unabhängig voneinander, vorgenommen, weshalb zwei Ergebnisse der Fehlerortermittlung erzeugt werden. Auch können in den Einrichtungen in Teilen unterschiedliche Algorithmen ausgeführt werden; beispielsweise können unterschiedliche Optimierungsverfahren eingesetzt werden. Anhand der Übereinstimmung der Ergebnisse von beiden Leitungsenden kann auf die Zuverlässigkeit des Ergebnisses geschlossen werden. Der am jeweiligen Leitungsende ermittelte Fehlerort kann z.B. in Prozent der Leitungslänge oder als Entfernung von der jeweiligen Messstelle (z.B. in km oder Meilen) direkt an der Einrichtung angezeigt werden oder in Form eines Signals oder Datentelegramms ausgegeben und an einen Betreiber des Energieversorgungsnetzes übermittelt werden. Bei den Einrichtungen an den beiden Leitungsenden kann es sich beispielsweise um - meist ohnehin vorhandene - Schutzgeräte zur Überwachung der Leitung auf Fehler handeln.

Alternativ dazu kann aber auch vorgesehen sein, dass die Ermittlung des Fehlerortes mittels einer dazu eingerichteten Einrichtung erfolgt, und der ermittelte Fehlerort von der Einrichtung ausgegeben wird.

Diese Einrichtung kann dabei an einem der Leitungsenden vorgesehen sein oder als eine zentrale Einrichtung, z.B. eine Datenverarbeitungseinrichtung in einer Stations- oder Netzleitstelle ausgebildet sein. Der ermittelte Fehlerort kann z.B. in Prozent der Leitungslänge oder als Entfernung von einer ausgewählten Messstelle (z.B. in km oder Meilen) direkt an der Einrichtung angezeigt werden oder in Form eines Signals oder Datentelegramms ausgegeben und an einen Betreiber des Energieversorgungsnetzes übermittelt werden.

Die oben genannte Aufgabe wird auch durch eine Einrichtung gemäß Patentanspruch 15 gelöst. Hierbei ist eine Einrichtung zum Ermitteln des Fehlerortes eines Fehlers auf einer Leitung eines elektrischen Energieversorgungsnetzes, mit einer Recheneinrichtung vorgesehen, die dazu eingerichtet ist, unter Verwendung von an einem ersten Leitungsende der Leitung gemessenen und zeitgestempelten ersten Strom- und/oder Spannungswerten und an einem zweiten Leitungsende der Leitung gemessenen und zeitgestempelten zweiten Strom- und/oder Spannungswerten nach dem Auftreten eines Fehlers auf der Leitung dessen Fehlerort zu bestimmen.

Erfindungsgemäß ist hierbei vorgesehen, dass die Recheneinrichtung dazu eingerichtet ist, unter Verwendung der zeitgestempelten ersten und zweiten Strom- und Spannungswerte an beiden Leitungsenden Profile von beim Auftreten des Fehlers sich entlang der Leitung in Richtung der Leitungsenden ausbreitenden Wanderwellen zu ermitteln, und dass die Recheneinrichtung dazu eingerichtet ist, den Fehlerort aus den für beide Leitungsenden ermittelten Profilen der Wanderwellen zu bestimmen, indem eine Zeitdifferenz bestimmt wird, mit der die Wanderwellen an den beiden Leitungsenden eintreffen, wobei die Zeitdifferenz aus einem Mustervergleich der für die Leitungsenden ermittelten Profile der Wanderwellen bestimmt wird.

Hierbei kann die Einrichtung vorteilhaft durch ein elektrisches Schutzgerät gebildet sein, das neben der Fehlerortung noch weitere Schutz- und Überwachungsfunktionen für das elektrische Energieversorgungsnetz (z.B. eine Distanzschutzfunktion, eine Überstromschutzfunktion oder eine Differentialschutzfunktion für die Leitung) durchführt. Alternativ dazu kann jedoch auch vorgesehen sein, dass die Einrichtung eine separate Fehlerlokalisier-Einrichtung ist.

Hinsichtlich der erfindungsgemäßen Einrichtung gelten alle zu dem erfindungsgemäßen Verfahren voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Die oben genannte Aufgabe wird außerdem auch durch ein System nach Anspruch 16 gelöst, der ein System zum Ermitteln des Fehlerortes eines Fehlers auf einer Leitung eines elektrischen Energieversorgungsnetzes angibt. Erfindungsgemäß sind zwei nach Anspruch 15 ausgebildete Einrichtungen vorgesehen, die mit einer Kommunikationsverbindung zum Datenaustausch miteinander in Verbindung stehen und zur Durchführung eines Verfahrens gemäß einem der Ansprüche 1 bis 14 ausgebildet sind.

Hinsichtlich des erfindungsgemäßen Systems gelten alle zu dem erfindungsgemäßen Verfahren und der erfindungsgemäßen Einrichtung voranstehend und nachfolgend gemachten Ausführungen und umgekehrt in entsprechender Weise. Auch hinsichtlich der Vorteile des erfindungsgemäßen Systems wird auf die zu dem erfindungsgemäßen Verfahren und der erfindungsgemäßen Einrichtung beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Es zeigen

Figur 1    eine schematische Ansicht einer Leitung eines Energieversorgungsnetzes mit einem System zur Ermittlung eines Fehlerortes;

Figur 2    eine Darstellung der elektrischen Parameter eines Leitungsabschnitts Δx zur Erläuterung der Bestimmung eines Fehlerortes nach dem Wanderwellenprinzip;

Figur 3    eine beispielhafte Übertragungscharakteristik eines Filters zur Erzeugung gefilterter Strom- und Spannungswerte;

Figur 4     beispielhafte Verläufe von Strom- und Spannungsmesswerten;

Figur 5     beispielhafte Verläufe von gefilterten Strom- und Spannungswerten;

Figur 6     beispielhafte Verläufe von aus den gefilterten Strom- und Spannungswerten erzeugten transformierten Strom- und Spannungswerten;

Figur 7     ein erstes beispielhaftes Diagramm mit Profilen von Wanderwellen zur Erläuterung einer Fehlerortbestimmung;

Figur 8     ein zweites beispielhaftes Diagramm mit Profilen von Wanderwellen zur Erläuterung einer Fehlerortbestimmung, wobei nur der erste Impuls der Wanderwellen betrachtet wird;

Figur 9     ein drittes beispielhaftes Diagramm mit Profilen von Wanderwellen zur Erläuterung einer Fehlerortbestimmung, wobei nur der erste Impuls der Wanderwellen betrachtet wird und die Profile unter Verwendung von Strommesswerten gebildet worden sind;

Figur 10    ein viertes beispielhaftes Diagramm mit Profilen von Wanderwellen zur Erläuterung einer Fehlerortbestimmung, wobei nur der erste Impuls der Wanderwellen betrachtet wird und die Profile unter Verwendung von Spannungsmesswerten gebildet worden sind;

Figur 11    eine erste Ansicht mehrerer Diagramme zur Erläuterung der Ermittlung einer Zeitdifferenz durch Mustervergleich mit Kreuzkorrelation;

Figur 12    eine zweite Ansicht mehrerer Diagramme zur Erläuterung der Ermittlung einer Zeitdifferenz durch Mustervergleich mit Kreuzleistungsspektrum und Winkelbetrachtung;

Figur 13    eine dritte Ansicht mehrerer Diagramme zur Erläuterung der Ermittlung einer Zeitdifferenz durch Mustervergleich mit Kreuzkorrelation oder quadratischer Zielfunktion; und

Figur 14    eine schematische Ansicht eines Ablaufdiagramms zur Erläuterung eines Ausführungsbeispiels eines Verfahrens zur Fehlerortung.

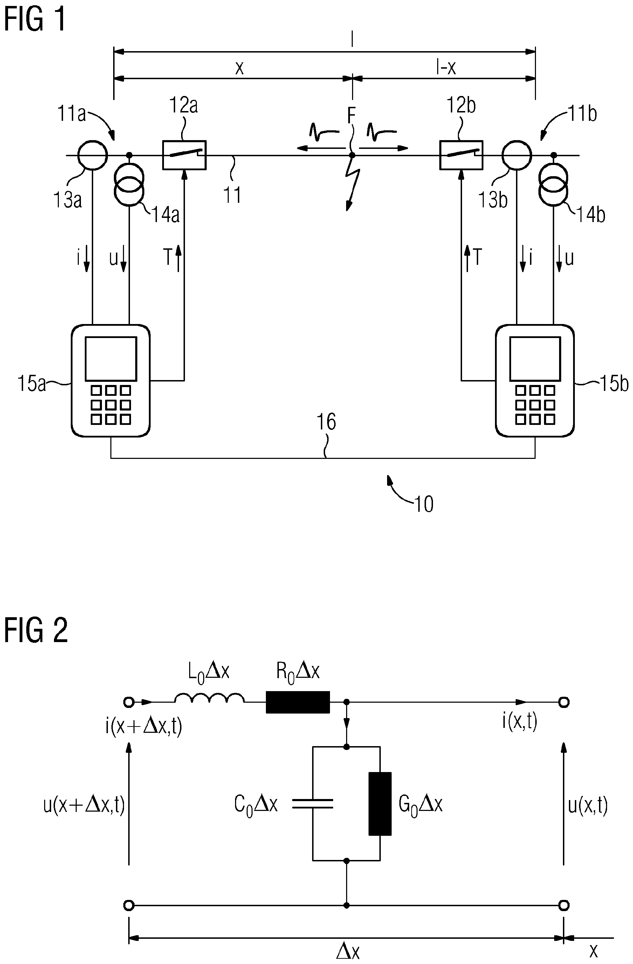

Figur 1 zeigt eine schematische Ansicht eines Systems 10 zum Ermitteln eines Fehlerortes in einem elektrischen Energieversorgungsnetz. Hierzu ist in Figur 1 eine elektrische Leitung 11 des Energieversorgungsnetzes in vereinfachter Darstellung gezeigt. Die Leitung habe die Länge l. Bei der Leitung 11 kann es sich um eine ein- oder eine mehrphasige Leitung handeln.

Die Leitung 11 wird an ihren Leitungsenden 11a und 11b durch Leistungsschalter 12a, 12b begrenzt und kann durch diese, insbesondere im Fehlerfall, vom restlichen, in Figur 1 nicht näher dargestellten Energieversorgungsnetz abgetrennt werden. An den Leitungsenden 11a, 11b sind zudem Messstellen vorgesehen, an denen mit in Figur 1 lediglich beispielhaft dargestellten Stromwandlern 13a, 13b und Spannungswandlern 14a, 14b Strom- und Spannungsmesswerte erfasst werden. Bei den Stromwandlern 13a, 13b und den Spannungswandlern 14a, 14b kann es sich um sogenannte konventionelle oder nicht konventionelle Wandler handeln. Sekundärseitig werden von den Wandlern Strommesswerte i und Spannungsmesswerte u abgegeben, bei denen es sich um analoge oder digitalisierte Werte handeln kann.

Mit den Stromwandlern 13a, 13b und den Spannungswandlern 14a, 14b stehen an den jeweiligen Leitungsenden 11a, 11b Einrichtungen 15a, 15b zur Ermittlung eines Fehlerortes in Verbindung. Die Einrichtungen 15a, 15b erfassen die Strom- und Spannungsmesswerte und führen ggf. eine Digitalisierung und/oder eine Vorverarbeitung durch. Dabei wird den jeweiligen Messwerten auch ein Zeitstempel zugeordnet, der den Zeitpunkt ihrer Erfassung genau angibt. Zu diesem Zweck weisen die Einrichtungen 15a, 15b interne Zeitgeber auf, die untereinander mittels gängiger Verfahren, z.B. GPS-Zeitimpulsen, IRIG-B, IEEE 1588, zeitlich synchronisiert sind. Aufgrund der Zeitstempelung sind die an beiden Leitungsenden 11a, 11b aufgenommenen Messwerte miteinander vergleichbar.

Bei den Einrichtungen 15a, 15b kann es sich beispielsweise um elektrische Schutzgeräte handeln, die neben einer Fehlerortungsfunktion auch weitere Schutz- und Überwachungsfunktionen durchführen. Beispielsweise kann es sich bei den Schutzgeräten um Distanzschutzgeräte, Differentialschutzgeräte oder Überstromschutzgeräte handeln, die den Betriebszustand der Leitung 11 anhand der erfassten Strom- und Spannungsmesswerte überwachen und im Fehlerfall ein Ausschaltsignal T an ihren jeweiligen Leistungsschalter 12a, 12b übermitteln, um diesen zum Öffnen seiner Schaltkontakte zu veranlassen.

Die Einrichtungen 15a, 15b sind dazu eingerichtet, im Fehlerfall auf der Leitung 11 den Fehlerort, also denjenigen Ort auf der Leitung, an dem ein Fehler (z.B. Kurzschluss, Erdschluss) aufgetreten ist, zu ermitteln und auszugeben. Hierzu verwenden sie die Strom- und/oder Spannungsmesswerte des eigenen Leitungsendes und des jeweils anderen Leitungsendes, die während des Fehlers erfasst worden sind. Zu diesem Zweck sind die Einrichtungen 15a, 15b über eine Kommunikationsverbindung 16, bei der es sich um eine beliebige geeignete drahtgebundene oder drahtlose Kommunikationsverbindung handeln kann, verbunden. Über die Kommunikationsverbindung 16 können die Einrichtungen 15a, 15b unter anderem ihre Strom- und/oder Spannungsmesswerte zur Ermittlung des Fehlerortes austauschen.

Die Einrichtungen 15a, 15b führen eine Fehlerortung nach dem sogenannten Wanderwellenprinzip aus. Dabei wird ausgenutzt, dass beim Auftreten eines Fehlers hochfrequente transiente Signalanteile im Strom und in der Spannung entstehen, die sich etwa mit Lichtgeschwindigkeit auf der Leitung 11 in beiden Richtungen ausbreiten. Dies ist in Figur 1 beispielhaft eingezeichnet. Hierzu wird angenommen, dass an einem Fehlerort F ein Fehler aufgetreten sei. Die Wanderwellen breiten sich wie dargestellt von dem Fehlerort F sowohl in Richtung des ersten Leitungsendes 11a als auch in Richtung des zweiten Leitungsendes 11b aus und können dort mit den Wandlern messtechnisch erfasst und mit den Einrichtungen 15a, 15b zur Fehlerortbestimmung ausgewertet werden. Von dem ersten Leitungsende aus gesehen liegt der Fehlerort F in einer Entfernung x, entsprechend liegt der Fehlerort F aus Sicht des zweiten Leitungsendes in einer Entfernung l-x. Die Einrichtungen werten wie nachfolgend im Einzelnen beschrieben die Strom- und Spannungsmesswerte aus und geben den Fehlerort F, beispielsweise als Entfernung oder Prozent der Leitungslänge l an.

Der Betreiber des Energieversorgungsnetzes kann den ermittelten Fehlerort F an ein Wartungsteam weitergeben, das daraufhin den Fehlerort aufsuchen und die Fehlerursache beheben kann. Hierzu ist eine möglichst genaue Ermittlung des Fehlerortes erforderlich. Nachfolgend wird eine Vorgehensweise zur genauen Fehlerortung beschrieben.

Zunächst soll eine kurze Erläuterung des Prinzips der Wanderwellen-Fehlerortung gegeben werden. Hierzu wird nachfolgend ein zweiseitiger Wanderwellen-Fehlerorter-Algorithmus erläutert, also ein Algorithmus, der mit Messwerten von beiden Leitungsenden 11a, 11b arbeitet. Dabei wird ein Ausbreitungsmodell für Wanderwellen entlang der Leitung 11 verwendet.

Zur Aufstellung des fraglichen Algorithmus wird die "Theorie der Langen Leitungen" eingesetzt. Es handelt sich hierbei um die modellhafte Abbildung einer elektrischen Leitung in Form von sogenannten "verteilten Parametern". Dies ist beispielhaft in Figur 2 dargestellt.

Der Figur 2 ist zu entnehmen, dass die Netzparameter wie Induktivitätsbelag $L_0$, Kapazitätsbelag $C_0$, Widerstandsbelag $R_0$ sowie Konduktivitätsbelag $G_0$ längs der Leitung verteilt sind. Basierend auf diesem Leitungsmodell können unter Verwendung von Kirchhoffschen-Gesetzen für das Teilstück $\Delta x$ der Leitung folgende Gleichungen für die Spannung u und den Strom i aufstellt werden:

$$u(x + \Delta x, t) = R_0 \Delta x \cdot i(x + \Delta x, t) + L_0 \Delta x \frac{\partial i(x + \Delta x, t)}{\partial t} + u(x, t) \qquad (1)$$

$$i(x + \Delta x, t) = G_0 \Delta x \cdot u(x, t) + C_0 \Delta x \frac{\partial u(x, t)}{\partial t} + i(x, t) \qquad (2)$$

Durch mathematische Umformungen lassen sich die Gleichungen (1) und (2) in die folgende Form überführen:

$$\frac{\partial u(x, t)}{\partial x} = R_0 \cdot i(x, t) + L_0 \frac{\partial i(x, t)}{\partial t} \qquad (3)$$

$$\frac{\partial i(x, t)}{\partial x} = G_0 \cdot u(x, t) + C_0 \frac{\partial u(x, t)}{\partial t} \qquad (4)$$

Diese Gleichungen (3) und (4) sind partielle Differentialgleichungen einer homogenen Leitung und werden üblicherweise als "Telegraphengleichungen" bezeichnet. Sie lassen sich auf beliebige Leiter verallgemeinern.

Durch die Betrachtung der Gleichungen (3) und (4) im Laplace-Bereich unter der Annahme von x als Parameter lassen sich viele in der Leitung entstehende Effekte wesentlich einfacher interpretieren:

$$\frac{\partial u(x, s)}{\partial x} = R_0 \cdot i(x, s) + sL_0 \cdot i(x, s) \qquad (5)$$

$$\frac{\partial i(x,s)}{\partial x} = G_0 \cdot u(x,s) + sC_0 \cdot u(x,s) \qquad (6)$$

Die Ableitung der Gleichungen (5) und (6) nach Parameter x ergibt:

$$\frac{\partial^2 u(x,s)}{\partial x^2} = Z(s)Y(s) \cdot u(x,s) \qquad (7)$$

$$\frac{\partial^2 i(x,s)}{\partial x^2} = Y(s)Z(s) \cdot i(x,s) \qquad (8)$$

Gleichungen (7) und (8) lassen sich unter Verwendung der Differentialgleichungstheorie für Spannung und Strom separat lösen:

$$U(x) = e^{-\gamma(s)x} \cdot A_1 + e^{\gamma(s)x} \cdot A_2 \qquad (9)$$

$$Z_c(s) \cdot I(x) = e^{-\gamma(s)x} \cdot A_1 - e^{\gamma(s)x} \cdot A_2 \qquad (10)$$

Bei der Lösung der Gleichungen (9) und (10) ist es möglich, die unbekannten Parameter $A_1$ und $A_2$ von den Anfangsbedingungen auszurechnen:

$$A_1 = \frac{1}{2}\left(U_1(s) + Z_c(s) \cdot I_1(s)\right) \qquad (11)$$

$$A_2 = \frac{1}{2}\left(U_1(s) - Z_c(s) \cdot I_1(s)\right) \qquad (12)$$

wobei $U_1$ und $I_1$ die Anfangsbedingungen bei x=0 darstellen. Darüber hinaus beinhalten Gleichungen (9) und (10) eine sogenannte Wellenimpedanz $Z_C$ und die Ausbreitungskonstante y, die sich aus den Leitungsparametern berechnen lassen:

$$\gamma(s)^2 = Z(s)Y(s) \qquad (13)$$

$$Z_c(s) = \gamma(s)^{-1} \cdot Z(s) \qquad (14)$$

Hierbei steht Z für die Längsimpedanz und Y für die Queradmittanz eines Abschnitts der Leitung. Die Werte werden jeweils längenbezogen angegeben.

Somit ergeben sich für die Gleichungen (9) und (10) folgende Formen:

$$U(x,s) = \frac{1}{2}e^{-\gamma(s)x} \cdot \left(U_1(s) + Z_c(s) \cdot I_1(s)\right) + \frac{1}{2}e^{\gamma(s)x} \cdot \left(U_1(s) - Z_c(s) \cdot I_1(s)\right) \qquad (15)$$

$$Z_c(s) \cdot I(x,s) = \frac{1}{2}e^{-\gamma(s)x} \cdot \left(U_1(s) + Z_c(s) \cdot I_1(s)\right) - \frac{1}{2}e^{\gamma(s)x} \cdot \left(U_1(s) - Z_c(s) \cdot I_1(s)\right) \qquad (16)$$

Gleichungen (15) und (16) stellen ein spannungs- bzw. strombezogenes Ausbreitungsmodell für Wanderwellen entlang der Leitung 11 dar.

Für die vorliegend beschriebene Wanderwellen-Fehlerortung wird die Fehlerspannung an dem zunächst unbekannten Fehlerort F betrachtet. Dabei wird auf den in Gleichung (15) beschriebenen Zusammenhang zurückgegriffen. Gleichung (15) setzt sich aus zwei Gliedern zusammen, von denen das eine eine sich vorwärts und das andere eine sich rückwärts bewegende Spannungswelle beschriebe. Die Spannungswelle am einen Leitungsende 11a lässt sich mathematisch fast identisch auch vom Leitungsende 11b an der Gegenseite beschreiben:

$$U(l-x,s) = \frac{1}{2}e^{-\gamma(s)(l-x)} \cdot \left(U_1(s) + Z_c(s) \cdot I_1(s)\right) + \frac{1}{2}e^{\gamma(s)(l-x)} \cdot \left(U_1(s) - Z_c(s) \cdot I_1(s)\right) \quad (17)$$

Zur Ortung des Fehlers wird davon ausgegangen, dass die von beiden Seiten ermittelte Spannung an der Fehlerstelle identisch sein muss:

$$U(x,s) = U(l-x,s) \quad (18)$$

Daraus resultiert folgende Gleichung (19), wobei der Index 1 für das erste Leitungsende und der Index 2 für das zweite Leitungsende stehen:

$$e^{-\gamma(s)x}\left(U_1(s) + Z_c(s) \cdot I_1(s)\right) - e^{\gamma(s)l}e^{-\gamma(s)x}\left(U_2(s) - Z_c(s) \cdot I_2(s)\right) =$$
$$e^{-\gamma(s)l}e^{\gamma(s)x}\left(U_2(s) + Z_c(s) \cdot I_2(s)\right) - e^{\gamma(s)x}\left(U_1(s) - Z_c(s) \cdot I_1(s)\right) \quad (19)$$

Wenn man Gleichung (19) nach einer bezogen auf Fehlerort x hinlaufenden und einer zurücklaufenden Welle sortiert, ergibt sich folgende Gleichung (20):

$$e^{-\gamma(s)x}\left[\left(U_1(s) + Z_c(s) \cdot I_1(s)\right) - e^{\gamma(s)l}\left(U_2(s) - Z_c(s) \cdot I_2(s)\right)\right] =$$
$$e^{\gamma(s)x}\left[e^{-\gamma(s)l}\left(U_2(s) + Z_c(s) \cdot I_2(s)\right) - \left(U_1(s) - Z_c(s) \cdot I_1(s)\right)\right] \quad (20)$$

Um die beiden Seiten der Gleichung analog zu beschreiben, wird von der linken Seite der Gleichung das Glied exp(γ(s)l) vor die Klammer gezogen:

$$e^{\gamma(s)(l-x)}\left[e^{-\gamma(s)l}\left(U_1(s) + Z_c(s) \cdot I_1(s)\right) - \left(U_2(s) - Z_c(s) \cdot I_2(s)\right)\right] =$$
$$e^{\gamma(s)x}\left[e^{-\gamma(s)l}\left(U_2(s) + Z_c(s) \cdot I_2(s)\right) - \left(U_1(s) - Z_c(s) \cdot I_1(s)\right)\right] \quad (21)$$

Gleichung (21) lässt sich dann in zwei zueinander analogen Formen darstellen:

$$\left[e^{-\gamma(s)(l)}\left(U_1(s) + Z_c(s) \cdot I_1(s)\right) - \left(U_2(s) - Z_c(s) \cdot I_2(s)\right)\right] =$$
$$e^{\gamma(s)(2x-l)}\left[e^{-\gamma(s)l}\left(U_2(s) + Z_c(s) \cdot I_2(s)\right) - \left(U_1(s) - Z_c(s) \cdot I_1(s)\right)\right] \quad (22a)$$

und

$$e^{\gamma(s)(l-2x)}\left[e^{-\gamma(s)l}\left(U_1(s) + Z_c(s) \cdot I_1(s)\right) - \left(U_2(s) - Z_c(s) \cdot I_2(s)\right)\right] =$$
$$\left[e^{-\gamma(s)(l)}\left(U_2(s) + Z_c(s) \cdot I_2(s)\right) - \left(U_1(s) - Z_c(s) \cdot I_1(s)\right)\right] \quad (22b)$$

Wenn man einen Wellenimpuls eines Leitungsendes als Bezug nimmt, wird der Wellenimpuls des anderen Leitungsendes um eine durch die γ definierte Zeit verschoben, weil näherungsweise die Beziehung (23) gilt:

$$e^{\gamma(s)(2x-l)} = e^{-s\frac{(l-2x)}{v}} \qquad (23)$$

In Gleichung (23) bedeuten v die Geschwindigkeit der Wanderwelle und I die Länge der Leitung; x bezeichnet den Fehlerort. Hier wurde angenommen, dass die Geschwindigkeit v der Wanderwelle in einem breiten Frequenzspektrum als konstant zu betrachten ist. Durch die Betrachtung der Gleichung (23) ergibt sich eine leicht in den Zeitbereich überführbare Gleichung, mit der die Profile der Wanderwellen abgebildet werden können:

$$e^{-s\frac{(2x-l)}{v}}\left[e^{-\gamma(s)(l)}\left(U_1(s)+Z_c(s)\cdot I_1(s)\right)-\left(U_2(s)-Z_c(s)\cdot I_2(s)\right)\right] = \\ \left[e^{-\gamma(s)l}\left(U_2(s)+Z_c(s)\cdot I_2(s)\right)-\left(U_1(s)-Z_c(s)\cdot I_1(s)\right)\right] \qquad (24)$$

Benennt man die Profile der Wanderwellen in den beiden Klammerausdrücken der Gleichung (24) mit $S_1$ und $S_2$, so ergibt sich

$$e^{-s\frac{(2x-l)}{v}}S_2(s) = S_1(s) \qquad (25)$$

Die Rücktransformation dieser Gleichung führt zu einem leicht interpretierbaren Ergebnis im Zeitbereich:

$$S_2(t-\tfrac{2x-l}{v}) = S_2(t-\tau) = S_1(t) \qquad (26)$$

Hier kann man sehen, dass sich anhand der Ermittlung der Zeitdifferenz $\tau$ zwischen den Wellenprofilen $S_1$ und $S_2$ eine Fehlerortung durchführen lässt. Darüber hinaus ist die äußere Form der beiden Wellenprofile $S_1$ und $S_2$ identisch. Diese Eigenschaft wird nachfolgend zur Bestimmung des Fehlerortes unter Heranziehung einer Mustererkennung genutzt.

Um die Wellenprofile jedoch zunächst aus den gemessenen Strom- und Spannungsmesswerten ableiten zu können, ist es wesentlich, nur die hochfrequenten Signalanteile der Messwerte zu betrachten. Zu diesem Zweck kann z.B. ein entsprechend ausgebildeter Filter eingesetzt werden, der die niederfrequenten Anteile aus den Messsignalen entfernt.

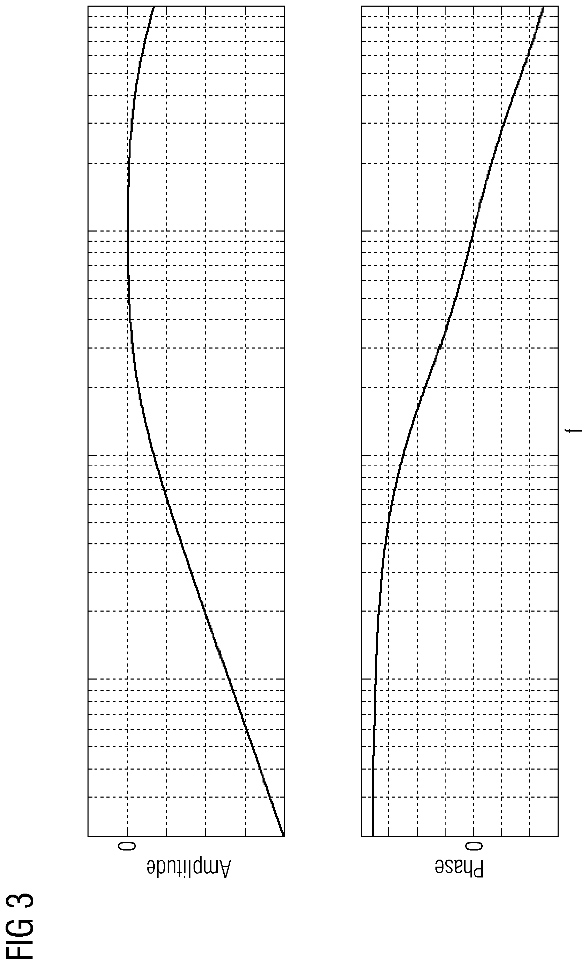

Figur 3 zeigt in diesem Zusammenhang die Übertragungsfunktion (Amplituden- und Phasengang) eines beispielhaften Filters, mit dessen Hilfe aus dem Verlauf der Strom- und Spannungsmesswerte die relevanten Frequenzen zur weiteren Analyse ausgefiltert werden, wobei gefilterte Strom- und Spannungswerte erzeugt werden. Ein beispielhafter Durchlassbereich eines geeigneten Filters kann bei etwa 30kHz bis 400kHz liegen. In diesem Bereich können üblicherweise in Energieversorgungsnetzen eingesetzte konventionelle primäre Messwandler die Signale in für die Fehlerortung ausreichender Qualität übertragen.

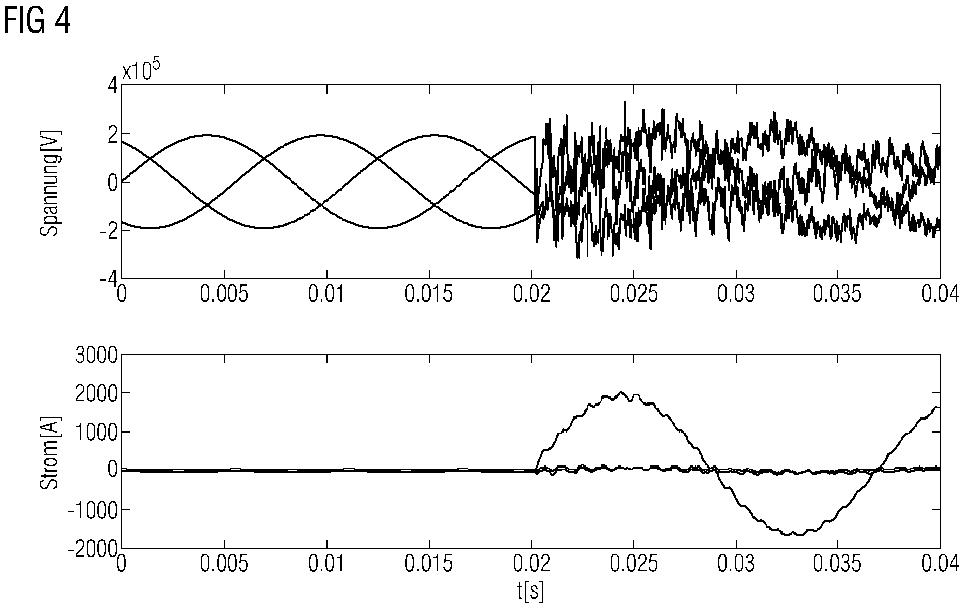

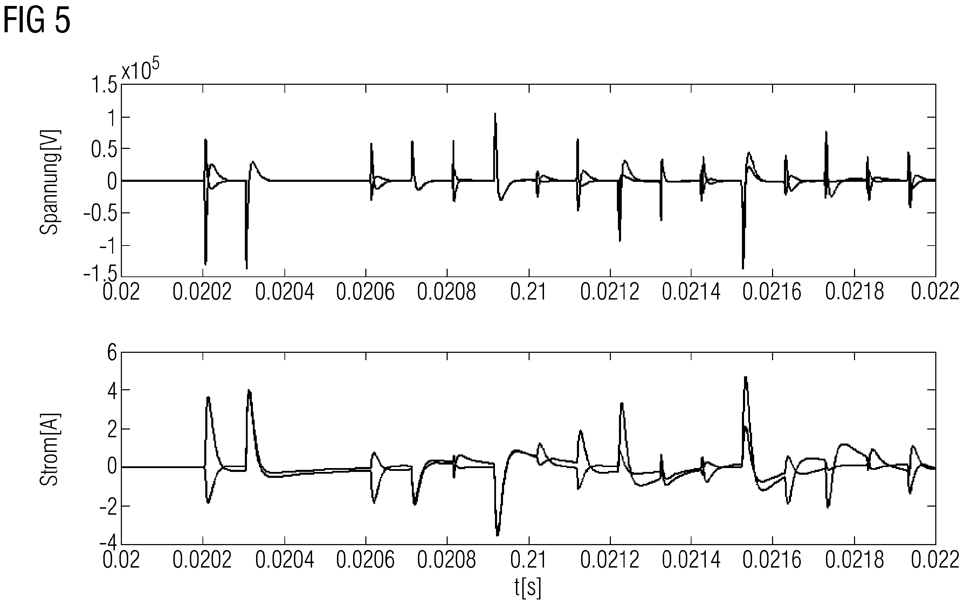

Wie sich der Filter auf die erfassten Strom- und Spannungsmesswerte auswirkt, ist in Figuren 4 und 5 beispielhaft dargestellt. Figur 4 zeigt einen beispielhaften Verlauf von Strom- und Spannungsmesswerten an einem Leitungsende einer dreiphasigen Hochspannungsleitung während eines einpoligen Fehlers in der Phase A. Der einpolige Fehler bewirkt einen Anstieg des Stromes in der fehlerbehafteten Phase A, während die Spannung in der Phase A einbricht. In den Strom- und Spannungssignalen sind nach Eintritt des Fehlers hochfrequente Transienten enthalten, die zur Fehlerortung ausgewertet werden sollen.

Durch Verwendung eines Filters (beispielsweise eines Bandpassfilters wie im Zusammenhang mit Figur 2 beschriebenen) können die hochfrequenten transienten Anteile der Strom- und Spannungsmesswerte herausgefiltert werden. Hierdurch entstehen gefilterte Strom- und Spannungswerte wie sie in Figur 5 beispielhaft dargestellt sind. Bei der Betrachtung der gefilterten Strom- und Spannungswerte ist zu bemerken, dass die nicht-fehlerbehafteten Phasen B und C übereinstimmende hochfrequente Muster aufweisen.

Üblicherweise umfassen die Leitungen in Energieversorgungsnetzen mindestens drei Phasenleiter. Somit ist es notwendig, die obigen für ein Einleitersystem angegebenen Gleichungen in einer Matrixform zu präsentieren. Die Vereinfachung solch eines Gleichungssystems kann durch eine modale bzw. Eigenwerttransformation erfolgen. Auf diese Art und Weise wird erreicht, dass die einzelnen Gleichungen des entstehenden Gleichungssystems voneinander entkoppelt werden und somit unabhängig voneinander betrachtet werden können. Darüber hinaus ermöglicht diese Transformation, die bereits aufgestellten Gleichungen in transformierten Komponenten zu betrachten.

Beispielhaft sei nachfolgend eine einfache symmetrische Leitung betrachtet, die folgende Parameter für einen Nennfrequenz von 60Hz besitzt:

$$Z = \begin{bmatrix} 0.187 + j0.858 & 0.098 + j0.3705 & 0.098 + j0.3705 \\ 0.098 + j0.3705 & 0.187 + j0.858 & 0.098 + j0.3705 \\ 0.098 + j0.3705 & 0.098 + j0.3705 & 0.187 + j0.858 \end{bmatrix} \Omega \qquad (27)$$

$$Y = 1e-5 \begin{bmatrix} j0.3 & -j0.036 & -j0.036 \\ -j0.036 & j0.3 & -j0.036 \\ -j0.036 & -j0.036 & j0.3 \end{bmatrix} S \qquad (28)$$

Hierbei steht Z für die Leitungsimpedanz und Y für die Leitungsadmittanz. Zur Entkopplung wird als modale Transformation beispielhaft die sogenannte "Clark-Transformation" herangezogen. Diese weist eine Transformationsmatrix T wie folgt auf; es entstehen sogenannte α-, β- und 0-Komponenten:

$$T = \frac{2}{3} \begin{bmatrix} 1 & -0.5 & -0.5 \\ 0 & \dfrac{\sqrt{3}}{2} & -\dfrac{\sqrt{3}}{2} \\ 0.5 & 0.5 & 0.5 \end{bmatrix} \qquad (29)$$

Mit der Clarke-Transformation lässt sich die oben genannten Matrizen (27) und (28) folgendermaßen transfor-mieren:

$$Z_{\alpha\beta0} = TZT^{-1} = \begin{bmatrix} 0.0894 + j0.487 & 0 & 0 \\ 0 & 0.0894 + j0.487 & 0 \\ 0 & 0 & 0.383 + j1.599 \end{bmatrix} \Omega \qquad (30)$$

$$Y_{\alpha\beta0} = TYT^{-1} = 1e^{-5} \begin{bmatrix} j0.336 & 0 & 0 \\ 0 & j0.336 & 0 \\ 0 & 0 & j0.229 \end{bmatrix} S \qquad (31)$$

In Verbindung mit Gleichungen (13) und (14) ergeben sich daraus die drei zu betrachtenden Ausbreitungskonstanten (Gleichung (32)) und Wellenimpedanzen (Gleichung (33)):

$$\gamma_{\alpha\beta0} = \begin{bmatrix} 0.0001 + j0.00128 & 0 & 0 \\ 0 & 0.0001 + j0.00128 & 0 \\ 0 & 0 & 0.0002 + j0.0019 \end{bmatrix} \qquad (32)$$

$$Z_{C\alpha\beta0} = 1e+2 \begin{bmatrix} 3.821 - j0.3475 & 0 & 0 \\ 0 & 3.821 - j0.3475 & 0 \\ 0 & 0 & 8.411 - j0.994 \end{bmatrix} \Omega \qquad (33)$$

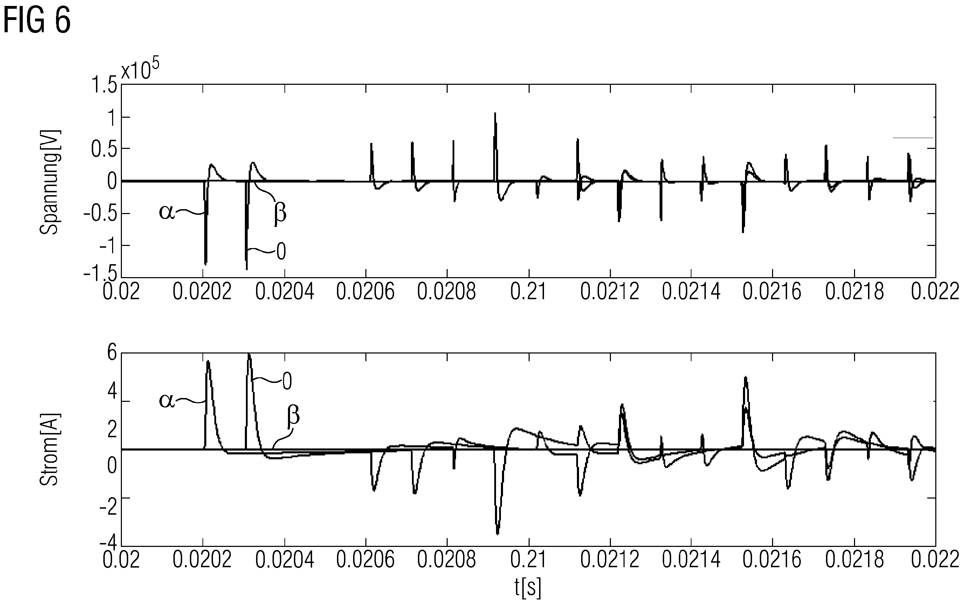

Durch die Analyse der Ausbreitungskonstante $\gamma$ lässt sich darauf schließen, welche der Modalen-Komponenten die größte Geschwindigkeit besitzt - diese wird bevorzugt zur weiteren Analyse verwendet. Darüber hinaus muss diejenige der Komponenten ausgewertet werden, die in einem ausreichenden Maß im Signal auftritt. Dies hängt stark von der Fehlerart ab. In Figur 6 sind die aus den gefilterten Strom- und Spannungswerten durch Transformation erzeugten transformierten Strom- und Spannungswerte dargestellt. Diese stellen die eigentlichen Wanderwellen dar, die zur Fehlerortung herangezogen werden.

Figur 6 ist zu entnehmen, dass im Beispielfall des einpoligen Fehlers in der Phase A die β-Komponente nicht auftritt. Außerdem ist zu erkennen, dass die 0-Komponente wesentlich langsamer als die α-Komponente ist.

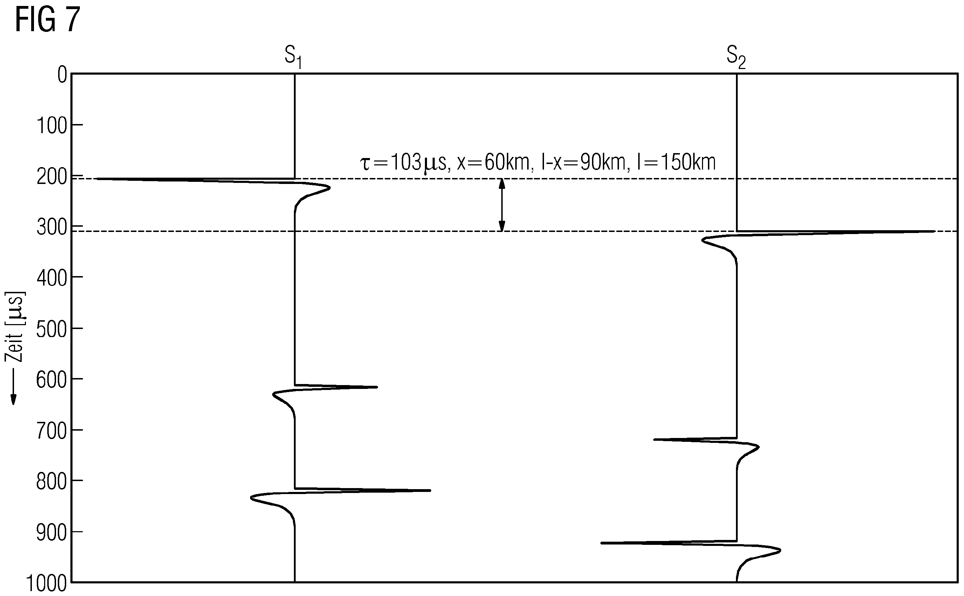

Wie oben bereits erwähnt, ist die äußere Form der Wellenprofile $S_1$ und $S_2$ gleich und zudem nicht vom Fehlerort abhängig. Die Zeitdifferenz τ ist somit ein eindeutiges Kriterium zur Angabe des Fehlerortes. Aus diesem Grund ist hier der gesuchte Parameter die Zeitdifferenz τ. Dies ist in Figur 7 angedeutet. In Figur 7 sind die Wellenprofile $S_1$ und $S_2$ entlang einer Zeitachse aufgetragen. Durch die Zeitstempelung der Strom- und Spannungsmesswerte mit synchronisierten Zeitgebern der Einrichtungen 15a, 15b (vgl. Figur 1) können die beiden Wellenprofile zeitlich einander zugeordnet werden. Da die Zeitbasis damit vorgegeben ist, kann die Ermittlung der Zeitdifferenz τ durch die Verschiebung eines Wellenprofils gegen das andere erfolgen. Die beste Überlappung von den beiden Wellenprofilen in der Funktion der Verschiebung gibt die korrekte Zeitdifferenz und damit den Fehlerort an, denn aus Gleichung (26) folgt für die Beziehung zwischen Fehlerort x und Zeitdifferenz τ:

$$x = \frac{(v \cdot \tau - l)}{2} \qquad (34)$$

In dem Beispiel in Figur 7 ergibt sich aus der ermittelten Zeitdifferenz τ=103μs ein Fehlerort von x=60km vom ersten Leitungsende bei einer Leitungslänge von 150km.

Da die beiden Wellenprofile lediglich zeitlich zueinander verschoben auftreten, aber ansonsten dieselbe äußere Form haben, kann zur Ermittlung der besten Überlappung der Wellenprofile und damit der Zeitdifferenz τ eine Mustererkennung eingesetzt werden. Die konkrete Vorgehensweise wird später detaillierter dargestellt.

Bei genauerer Betrachtung der Gleichungen (24) und (25) fällt auf, dass zur Berechnung der Wellenprofile $S_1$ und $S_2$ ein relativ umfangreicher Datenaustausch synchron gestempelter Messwerte zwischen den Einrichtungen 15a und 15b erforderlich ist. Bei einer Offline-Fehlerortung spielt diese Tatsache keine wesentliche Rolle, weil hierfür die kompletten Aufzeichnungen von Wanderwellen zur Verfügung gestellt und ausgewertet werden können. Hierfür können die Messwerte in weitgehend beliebig langer Zeit aus den Einrichtungen abgerufen und mit einer separaten Datenverarbeitungseinrichtung ausgewertet werden. Bei der Online-Fehlerortung durch die Einrichtungen 15a und 15b selbst kann es jedoch zu Problemen kommen, wenn die Kommunikationsverbindung 16 zwischen den Einrichtungen 15a, 15b keine ausreichende Bandbreite aufweist.

Zu diesem Zweck wäre es vorteilhaft, wenn die für die Fehlerortung zu übertragende Datenmenge reduziert werden könnte. Hierfür wird vorgeschlagen, nur den ersten Impuls der jeweiligen Wanderwelle an die Gegenseite überträgt. Der erste Impuls des Profils $S_1$ bzw. $S_2$ einer Wanderwelle beinhaltet zudem keine Information über das Verhalten der Wanderwelle von dem Gegenende, weil diese Information erst nach einer Reflektion am Gegenende und der anschließenden Laufzeit über die ganze Leitung (exp(-γ(s)·l)) am lokalen Leitungsende eintrifft. Aus diesem Grund können die oben gegebenen Gleichungen (24) und (25) wie folgt reduziert werden:

$$e^{-s\frac{(2x-l)}{v}}\left[-\left(U_2(s) - Z_c(s) \cdot I_2(s)\right)\right] = \left[-\left(U_1(s) - Z_c(s) \cdot I_1(s)\right)\right] \qquad (35)$$

bzw.

$$e^{-s\frac{(2x-l)}{v}} S_{2,R}(s) = S_{1,R}(s) \qquad (36)$$

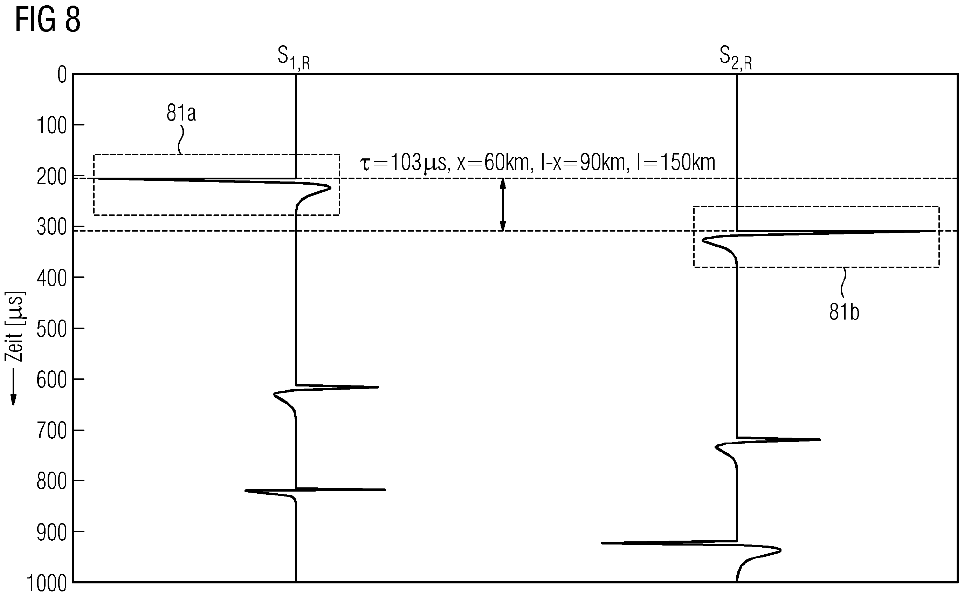

wobei $S_{1,R}$ und $S_{2,R}$ für die entsprechend auf den ersten Impuls reduzierten Profile der Wanderwellen stehen. Diese Ausführungsform ist in Figur 8 angedeutet. Die Verläufe der Wellenprofile $S_{1,R}$ und $S_{2,R}$ sind hier jeweils nach Gleichung (35) bzw. (36) bestimmt worden. Der für die Auswertung der Wellenprofile $S_{1,R}$ und $S_{2,R}$ zur Fehlerortung herangezogene erste Wellenimpuls ist in Figur 8 durch Umrandungen 81a und 81b hervorgehoben. Wie im Vergleich zu Figur 7 erkannt werden kann, wird der Verlauf des jeweils ersten Wellenimpulses durch diese Vereinfachung nicht beeinflusst, da wie erwähnt hier noch keine Überlagerung mit Reflektionen vom jeweils anderen Leitungsende stattgefunden hat. Unterschiede in den Wellenprofilen $S_1$ und $S_{1,R}$ bzw. $S_2$ und $S_{2,R}$ finden sich somit erst im weiteren Verlauf der jeweiligen Profile. Entsprechend liefert die mittels einer Mustererkennung durchgeführte Bestimmung der Zeitdifferenz τ auch denselben Wert wie bei der Auswertung der vollständigen Profile $S_1$ und $S_2$, so dass die Fehlerortung mit derselben Genauigkeit auch mit den reduzierten Profilen S$_{1,R}$ und S$_{2,R}$ durchgeführt werden kann.

Bei der Betrachtung der reduzierten Gleichungen (35) und (36) lässt sich außerdem feststellen, dass die Wellenprofile S$_{1,R}$ und S$_{2,R}$ aus einer linearen Kombination von Spannungen und Strömen gebildet werden. Da die Wellenimpedanz Z$_C$ in dem zu betrachtendem Frequenzbereich als konstant anzunehmen ist, können die Verläufe der Wellenprofile hinsichtlich Strömen und Spannungen näherungsweise separat voneinander betrachtet werden. Hierdurch lässt sich einerseits die zu übertragende Datenmenge weiter verringern und andererseits der Aufwand für den Mustervergleich zur Ermittlung der Zeitdifferenz $\tau$ reduzieren.

Somit gilt für eine nur auf Strömen beruhende Betrachtung:

$$e^{-s\frac{(2x-l)}{v}}\left[(I_2(s))\right] \cong \left[(I_1(s))\right] \qquad (37)$$

bzw.

$$e^{-s\frac{(2x-l)}{v}}S_{2,R}^{I}(s) \cong S_{1,R}^{I}(s) \qquad (38)$$

Dabei stehen S$^I_{1,R}$ und S$^I_{2,R}$ für die auf den ersten Wellenimpuls reduzierten strombasierten Profile der Wanderwellen an dem jeweiligen Leitungsende.

Entsprechend gilt für eine nur auf Spannungen beruhende Betrachtung:

$$e^{-s\frac{(2x-l)}{v}}\left[-(U_2(s))\right] \cong \left[-(U_1(s))\right] \qquad (39)$$

bzw.

$$e^{-s\frac{(2x-l)}{v}}S_{2,R}^{V}(s) \cong S_{1,R}^{V}(s) \qquad (40)$$

Dabei stehen S$^V_{1,R}$ und S$^V_{2,R}$ für die auf den ersten Wellenimpuls reduzierten spannungsbasierten Profile der Wanderwellen an dem jeweiligen Leitungsende.

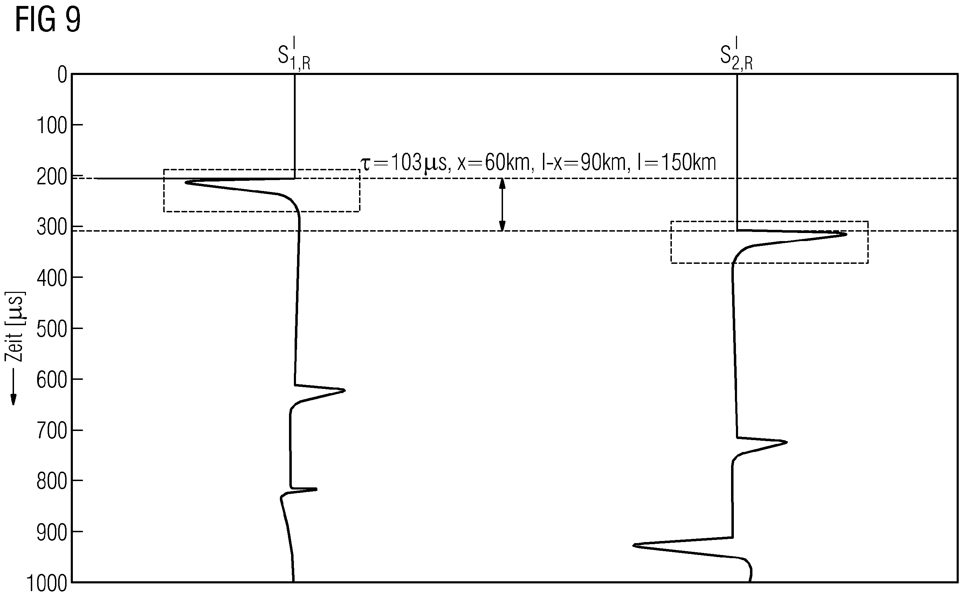

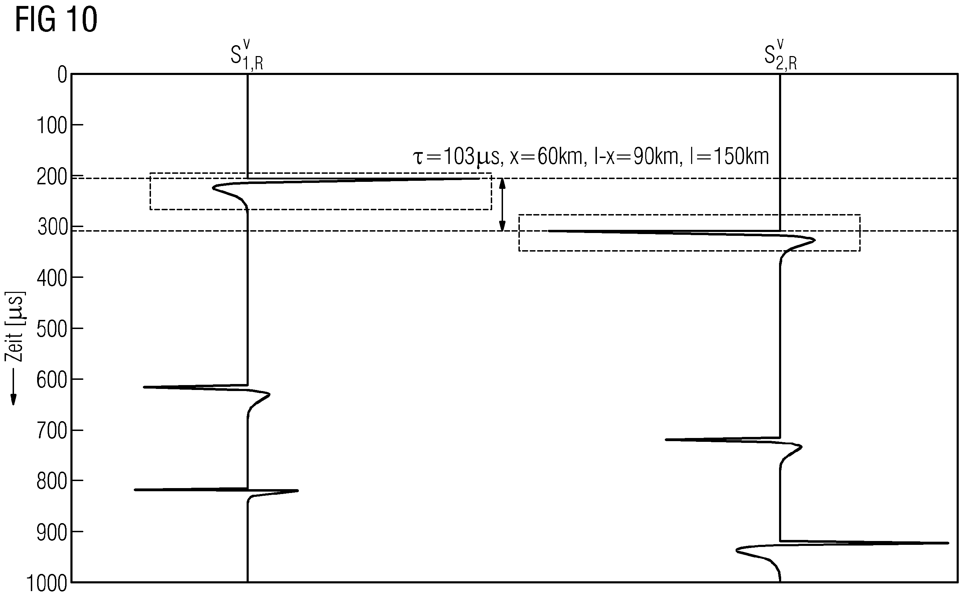

Die Verläufe der entsprechenden Wellenprofile S$^I_{1,R}$ und S$^I_{2,R}$ und S$^V_{1,R}$ und S$^V_{2,R}$ sind in Figuren 9 und 10 angedeutet. Die für die Auswertung herangezogenen ersten Wellenimpulse sind wie in Figur 8 durch Einrahmungen hervorgehoben. Man erkennt im Vergleich zur Figur 8 eine weitere Vereinfachung der Profilformen. Die Auswertung hinsichtlich der Zeitdifferenz $\tau$ liefert dennoch eine akzeptable Genauigkeit für die Fehlerortung.

Nachfolgend wird beschrieben, wie mit Hilfe einer hinsichtlich der Wellenprofile an den Leitungsenden durchgeführten Mustererkennung eine Ermittlung der Zeitdifferenz $\tau$ und damit des Fehlerortes x erfolgen kann. Allen beschriebenen Methoden liegt zunächst die bereits erwähnte Erkenntnis zugrunde, dass sich die Wellenprofile an beiden Leitungsenden zwar durch eine zeitliche Verschiebung unterscheiden, die äußere Form beider Wellenprofile jedoch identisch ist. Um die korrekte Zeitdifferenz $\tau$ zu bestimmen, muss somit zunächst durch Verschiebung auf der Zeitachse die bestmögliche Überlappung der äußeren Formen der Wellenprofile gefunden werden. Der Wert der vorgenommen zeitlichen Verschiebung entspricht daraufhin der gesuchten Zeitdifferenz $\tau$.

Die Ermittlung der Zeitdifferenz $\tau$, die sich aus der besten Überlappung der Wellenprofile ergibt, kann in verschiedenen geeigneten Weisen durchgeführt werden. Nachfolgend sollen beispielhaft einige mögliche Vorgehensweisen erläutert werden. Grundsätzlich kann die Mustererkennung sowohl hinsichtlich der vollständigen Wellenprofile S$_1$, S$_2$ als auch hinsichtlich der vorstehend beschriebenen reduzierten Wellenprofile S$_{1,R}$, S$_{2,R}$ bzw. S$^I_{1,R}$, S$^I_{2,R}$ oder S$^V_{1,R}$, S$^V_{2,R}$ durchgeführt werden. Die Frage, welches Wellenprofil für die Auswertung verwendet werden soll, muss nach einer Abwägung der zur Datenübertragung vorhandenen Bandbreite und der geforderten Ortungsgenauigkeit beantwortet werden. Dabei können die Arten der zur Auswertung herangezogenen Wellenprofile beispielsweise als Parameter in den Einrichtungen 15a, 15b auswählbar sein, so dass seitens des Betreibers des Energieversorgungsnetzes für den jeweiligen Einzelfall die geeignete Auswertungsgrundlage ausgewählt werden kann.

Die Bestimmung der Zeitdifferenz $\tau$ kann beispielsweise durch Bildung einer Kreuzkorrelation zwischen den heranzuziehenden Wellenprofilen S$_1$, S$_2$ bzw. S$_{1,R}$, S$_{2,R}$ bzw. S$^I_{1,R}$, S$^I_{2,R}$ oder S$^V_{1,R}$, S$^V_{2,R}$ erfolgen. Hierzu kann folgende Gleichung (am Beispiel von S$_1$ und S$_2$) verwendet werden:

$$K_{S_1 S_2}(\tau) = \frac{1}{T_F} \int\limits_{t_0}^{t_0+T_F} S_1(t) \cdot S_s(t+\tau)\, dt \qquad (41)$$

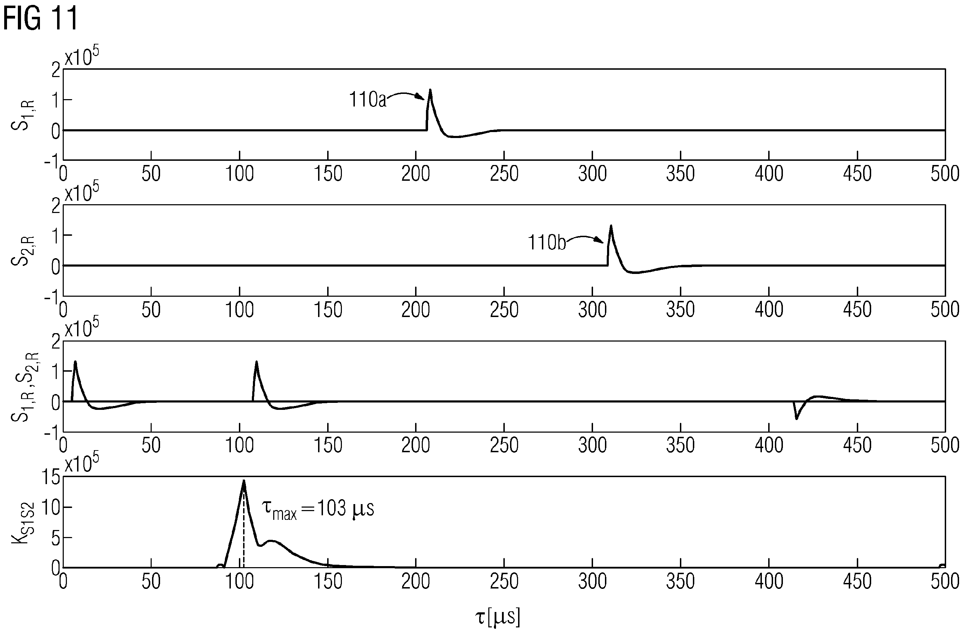

Dabei steht $T_F$ für die Dauer eines Messfensters. Das Maximum dieser Kurve deutet auf die korrekte Zeitdifferenz $\tau$ und damit gemäß Gleichung (34) auf den Fehlerort x hin. Diese Vorgehensweise ist beispielhaft in Figur 11 angedeutet. Figur 11 zeigt hierzu vier Diagramme, von denen die beiden oberen die Verläufe der auf den ersten Wellenimpuls reduzierten Wellenprofile $S_{1,R}$ und $S_{2,R}$ angeben. Man erkennt die zeitliche Verschiebung der Wellenimpulse 110a und 110b. Im dritten Diagramm sind beide Wellenprofile gemeinsam dargestellt, wobei der Zeitpunkt $t_0=0$ auf den Beginn des ersten Wellenprofils gelegt wurde. Im vierten Diagramm ist schließlich der Verlauf der Kreuzkorrelation $K_{S1S2}$ gemäß Gleichung (41) dargestellt. Das Maximum der Kurve gibt die Zeitverschiebung $\tau$ der beiden Wellenprofile $S_{1,R}$ und $S_{2,R}$ an und kann zur Bestimmung des Fehlerortes verwendet werden.

Eine entsprechende Suche nach der korrekten Zeitdifferenz $\tau$ lässt sich auch im Frequenzbereich durchführen. Diese Betrachtungsweise kann vorteilhaft sein, da man sich hierbei auf die wesentlichen Frequenzkomponenten beschränken kann. Dann werden die betrachteten Wellenprofile zu:

$$\underline{S}_1(f) = FFT\{S_1(t)\}, \quad \underline{S}_2(f) = FFT\{S_2(t)\}$$

Durch die Bildung eines sogenannten Kreuzleistungsspektrums

$$K_{S_1 S_2}(f) = \underline{S}_1(f) \cdot \underline{S}_2^*(f) \qquad (42)$$

(der Stern * deutet hierbei das konjugiert Komplexe an) lässt sich in einem weiteren Schritt die korrekte Zeitdifferenz $\tau$ finden, indem man nach dem Maximum der folgenden Funktion sucht:

$$K_{S_1 S_2}(f,\tau) = \underline{S}_1(f) \cdot \left(\underline{S}_2(f) e^{i2\pi f\tau}\right)^* \qquad (43)$$

Gemäß Gleichung (43) müsste das Maximum der Kurve theoretisch für jede Frequenz bei gleichen Werten der Zeitdifferenz $\tau$ liegen. Bei der praktischen Anwendung ist jedoch zu empfehlen, für die Zeitdifferenz $\tau$ eine kumulierte Summe von allen wirksamen Frequenzen verwenden und diese zur Suche nach dem Maximum zu verwenden:

$$\tau = \max\left(\sum K_{S_1 S_2}(f,\tau)\right) \qquad (44a)$$

Außerdem kann - alternativ oder zusätzlich - auch der Winkel des Kreuzleistungsspektrums betrachtet werden:

$$\tau = angle\left(\sum K_{S_1 S_2}(f,\tau)\right) \qquad (44b)$$

Ein Nulldurchgang des Winkels deutet auf ein Maximum der Kurve des Kreuzleistungsspektrums und damit die korrekte Zeitdifferenz $\tau$ hin.

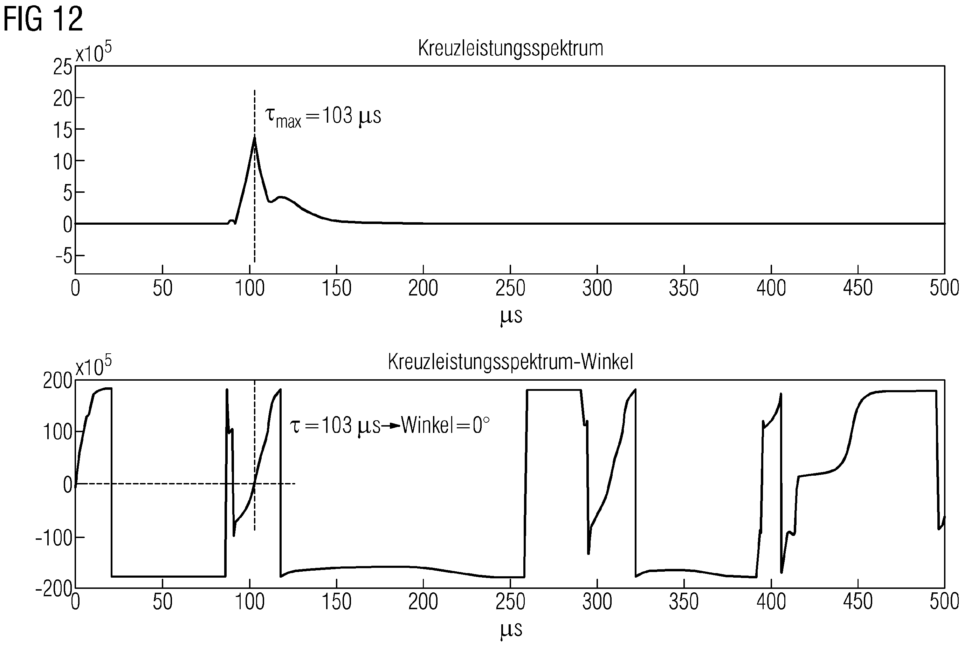

Hierzu ist in Figur 12 im oberen Diagramm der Verlauf der Kurve des Kreuzleistungsspektrums und im unteren Diagramm der Verlauf des Winkels des Kreuzleistungsspektrums dargestellt. Man erkennt, dass an der Stelle des Maximums des Kreuzleistungsspektrums der Verlauf des Winkels einen Nulldurchgang hat. So kann das Winkelkriterium beispielsweise zusätzlich zum Kreuzleistungsspektrum verwendet werden, um dessen Maximum noch genauer zu bestimmen.

Schließlich kann die Zeitdifferenz $\tau$ auch mittels einer quadratischen Zielfunktion bestimmt werden, wobei in diesem Fall nach dem Minimum gesucht werden muss:

$$Q_{S_1 S_2}(\tau) = \int\limits_{t_0}^{t_0+T_F} \left[S_1(t) - S_2(t+\tau)\right]^2 dt \qquad (45)$$

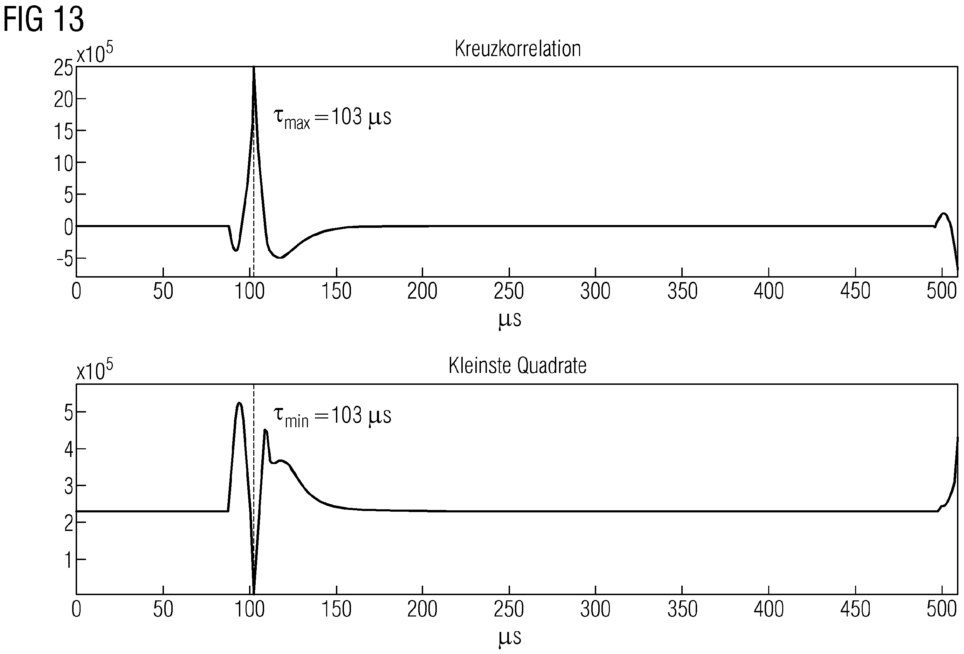

Der Verlauf der quadratischen Zielfunktion nach Gleichung (45) ist im Vergleich zum Verlauf der Kreuzkorrelation nach Gleichung (41) beispielhaft in Figur 13 dargestellt. Man erkennt, dass das Minimum der quadratischen Zielfunktion im unteren Diagramm an derselben Stelle liegt wie das Maximum der Kreuzkorrelation im oberen Diagramm.

Auch die quadratische Zielfunktion lässt sich alternativ im Frequenzbereich lösen:

$$Q_{S_1 S_2}(f,\tau) = \left(\underline{S}_1(f) - \left(\underline{S}_2(f)e^{i2\pi f\tau}\right)\right) \cdot \left(\underline{S}_1(f) - \left(\underline{S}_2(f)e^{i2\pi f\tau}\right)\right)^* \qquad (46)$$

Im Fall einer verlustlosen oder zumindest verlustarmen Leitung werden sich die äußeren Formen der Signale $S_1$, $S_2$ bzw. $S_{1,R}$, $S_{2,R}$ bzw. $S^I_{1,R}$, $S^I_{2,R}$ oder $S^V_{1,R}$ tatsächlich kaum voneinander unterscheiden. Somit können die hier vorgeschlagenen Methoden zur Mustererkennung für die Fehlerortung als völlig ausreichend angesehen werden. Betrachtet man jedoch eine Leitung, in der die Verluste nicht mehr vernachlässigt werden dürfen, kann man eine frequenzabhängige Korrektur einführen, die die Form der Kurven verbessert und somit zur genaueren Ortung des Fehlers beiträgt (nachfolgend beispielhaft für $\underline{S}_2$):

$$\underline{S}_{2,korr}(f) = \underline{S}_2(f) \cdot e^{\mathrm{Re}\{\gamma(f)\} \cdot \frac{(t \cdot v_f - l)}{2}} \qquad (47)$$

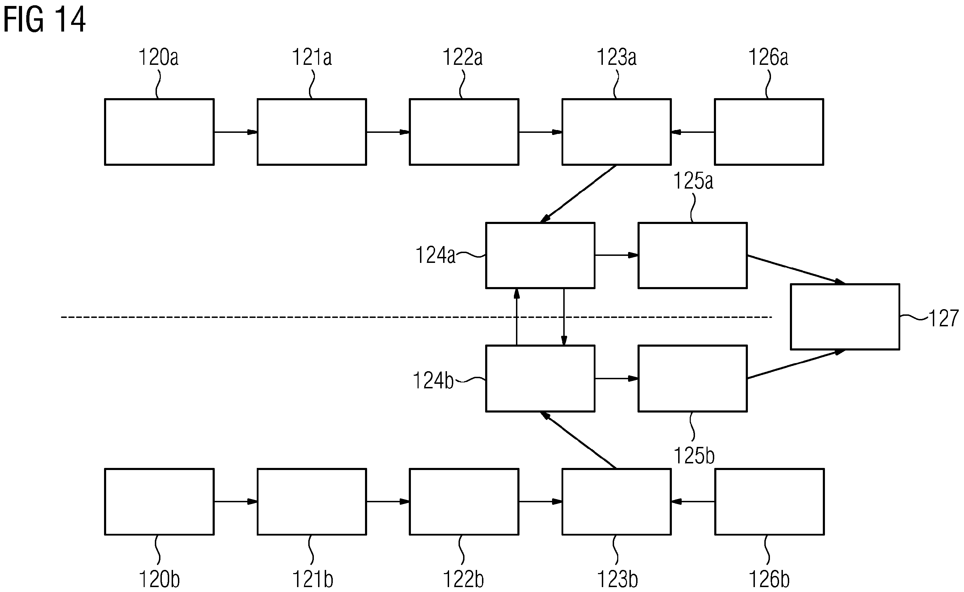

Hierbei wurde angenommen, dass die Propagationszeit in dem zu betrachtenden Frequenzspektrum konstant bleibt. Ist dies nicht der Fall, kann man auch zusätzlich eine frequenzabhängige Korrektur auf die Propagationszeit der Wanderwelle einführen. Figur 14 zeigt abschließend ein schematisches Ablaufdiagramm eines Ausführungsbeispiels eines Verfahrens zur Ermittlung eines Fehlerortes. Dabei finden die Verfahrensschritte oberhalb der gestrichelten Linie in der Einrichtung 15a am ersten Leitungsende 11a, diejenigen unterhalb der gestrichelten Linie in der Einrichtung 15b am zweiten Leitungsende 11b (vgl. Figur 1) statt.

Mit den Einrichtungen 15a, 15b an beiden Leitungsenden werden in Schritten 120a und 120b jeweils die lokalen Ströme und Spannungen gemessen und entsprechende Strom- und Spannungsmesswerte erzeugt. Diese Messwerte liegen als Abtastwerte der Strom- und Spannungssignale der Leitung 11 vor. Ein Beispiel für die erfassten Strom- und Spannungsmesswerte ist in Figur 4 ersichtlich.

Damit nur die hochfrequenten transienten Anteile (Wanderwellen) der jeweiligen Strom- bzw. Spannungsmesswerte erfasst werden, findet in Schritten 121a und 121b jeweils eine Filterung (z.B. durch einen Bandpassfilter) statt. Durch die Wahl der Eckfrequenzen z.B. des Bandpassfilters kann das Verfahren an die Eigenschaften der Wandler 13a, 13b und 14a, 14b angepasst werden. Stellen diese Wandler nur eine mittlere Bandbreite, z.B. nur bis 10kHz, zur Verfügung, dann müssen die Filter die Bandbreite der Signale auf die Bandbreite der Wandler begrenzen. Je nach Phasenfehler der eingesetzten Wandler ist dann mit einer etwas geringeren Messgenauigkeit zu rechnen. Können die Wandler eine höhere Bandbreite, z.B. bis 500kHz, bereitstellen, dann sollten die Filter entsprechend dimensioniert werden.

In den Schritten 121a, 121b werden gefilterte Strom- und Spannungswerte erzeugt, wie sie beispielhaft in Figur 5 gezeigt sind. Eine beispielhafte Übertragungscharakteristik eines geeigneten Filters ist in Figur 3 gezeigt.

Außerdem erweist es sich als vorteilhaft, wenn die Filtercharakteristik des zur Filterung der Strom- bzw. Spannungsmesswerte verwendeten Filters solche Frequenzanteile bedämpft, in denen die Messwandler 13 bzw. 14 Messfehler aufweisen.

Die jeweiligen Wanderwellen werden in Schritten 122a und 122b jeweils durch eine Transformation (z.B. Clarke-Transformation) behandelt, z.B. um die phasenbezogenen Anteile zu entkoppeln. Dabei werden transformierte Strom- und Spannungswerte erzeugt, wie sie beispielhaft in Figur 6 gezeigt sind.

Um das Fehlerortungsverfahren nur bei Bedarf, d.h. im Fehlerfall, zu starten und/oder um das Messfenster für die Auswertung richtig zu positionieren, kann zudem pro Seite jeweils in Schritten 123a und 123b ein transienter Sprung ermittelt werden, der z.B. als Trigger für die Messfensterpositionierung eingesetzt wird. Die Länge des Messfensters sollte bevorzugt mindestens das Doppelte der Propagationszeit der Wanderwelle in der ausgewählten Modalkomponente betragen. Die Sprungerkennung kann hinsichtlich der transformierten oder der gefilterten Strom- und Spannungswerte oder auch hinsichtlich der ursprünglichen Strom- und Spannungsmesswerte stattfinden.

Falls die nachfolgende Auswertung im Frequenzbereich stattfinden soll, findet in Schritten 124a und 124b eine Überführung der transformierten Strom- und Spannungswerte in den Frequenzbereich statt. Dies erfolgt bevorzugt mittels einer Fast Fourier Transformation (FFT) bzw. Discrete Fourier Transformation (DFT).

Außerdem kann bei verlustbehafteten Leitungen hierbei eine frequenzabhängige Korrektur der Wanderwellenprofile (vgl. Gleichung (47)) stattfinden. Diese wird in Schritten 126a und 126b bereitgestellt

Wie durch die Pfeile zwischen den Blöcken der Schritte 124a und 124b angedeutet, werden die sich ergebenden Werte im Frequenzbereich zwischen den Einrichtungen 15a und 15b (vgl. Figur 1) ausgetauscht. Dies erfolgt über die Kommunikationsverbindung 16.

Mit den eigenen Werten und den Werten vom jeweils anderen Leitungsende führen die Einrichtungen 15a und 15b dann in Schritten 125a und 125b jeweils eine Fehlerortsuche mittels Mustererkennung wie oben beschrieben aus. Dabei können in Schritten 125a und 125b beispielsweise die Zielfunktionen gemäß Gleichungen (43) oder (46) verarbeitet werden. Findet eine Auswertung im Zeitbereich statt, können stattdessen die Daten im Zeitbereich ausgetauscht und nach den Gleichungen (41) und (45) ausgewertet werden. Wie oben beschrieben, wird dabei die bestmögliche Überlappung der Wellenprofile der Wanderwellen an beiden Leitungsenden gesucht. Hieraus ergibt sich eine Zeitdifferenz $\tau$, die nach Gleichung (34) den Fehlerort x angibt.

In Schritt 127 wird dann der ermittelte Fehlerort ausgegeben. Gemäß Figur 14 findet dies in einem gemeinsamen Ausgabeschritt statt. Stattdessen kann auch eine separate Ausgabe durch jede der beiden Einrichtungen 15a bzw. 15b erfolgen.

Die Einrichtungen 15a und 15b besitzen üblicherweise eine Recheneinrichtung, in der die Schritte 120a/b bis 127 durchgeführt werden. Dabei kann es sich z.B. um einen Mikroprozessor handeln, der auf eine entsprechende Gerätesoftware zugreift, die sich in einem Speicher der jeweiligen Einrichtung befindet. Alternativ kann es sich auch um einen Rechenbaustein mit hardwarebestimmter Programmierung handeln, z.B. einen ASIC oder FPGA.

In Figuren 1 und 14 wurde ein System zum Ermitteln eines Fehlerortes gezeigt, bei dem der Fehlerort mit zwei Einrichtungen 15a und 15b ermittelt wird, die sich jeweils an einem Leitungsende 11a bzw. 11b befinden. Stattdessen kann auch eine zentrale Einrichtung vorgesehen sein, der die Strom- und Spannungsmesswerte von den Leitungsenden zugeführt werden. Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1. Verfahren zum Ermitteln des Fehlerortes (F) eines Fehlers auf einer Leitung (11) eines elektrischen Energieversorgungsnetzes, bei dem

   - an einem ersten Leitungsende (11a) der Leitung (11) erste Strom- und/oder Spannungswerte gemessen und mit einem Zeitstempel versehen werden;
   - an einem zweiten Leitungsende (11b) der Leitung (11) zweite Strom- und/oder Spannungswerte gemessen und mit einem Zeitstempel versehen werden; und
   - unter Verwendung der zeitgestempelten ersten und zweiten Strom- und/oder Spannungswerte nach dem Auftreten eines Fehlers auf der Leitung (11) dessen Fehlerort (F) bestimmt wird;

   **dadurch gekennzeichnet, dass**

   - unter Verwendung der zeitgestempelten ersten und zweiten Strom- und/oder Spannungswerte an beiden Leitungsenden (11a, 11b) Profile von beim Auftreten des Fehlers sich entlang der Leitung in Richtung der Leitungsenden (11a, 11b) ausbreitenden Wanderwellen ermittelt werden; und
   - der Fehlerort (F) aus den für beide Leitungsenden (11a, 11b) ermittelten Profilen der Wanderwellen bestimmt wird, indem eine Zeitdifferenz bestimmt wird, mit der die Wanderwellen an den beiden Leitungsenden eintreffen, wobei die Zeitdifferenz aus einem Mustervergleich der für die Leitungsenden (11a, 11b) ermittelten Profile der Wanderwellen bestimmt wird.

2. Verfahren nach Anspruch 1,
   **dadurch gekennzeichnet, dass**

   - zum Mustervergleich der Profile der Wanderwellen eine Kreuzkorrelation der Profile durchgeführt wird.

3. Verfahren nach Anspruch 1 oder 2,
   **dadurch gekennzeichnet, dass**

   - zum Mustervergleich ein Winkel des Kreuzleistungsspektrums der Profile der Wanderwellen herangezogen wird.

4. Verfahren nach Anspruch 1,

**dadurch gekennzeichnet, dass**

- zum Mustervergleich eine Minimierung einer aus der Differenz der Profile der Wanderwellen gebildeten Zielfunktion durchgeführt wird.

**5.** Verfahren nach einem der vorangehenden Ansprüche,
**dadurch gekennzeichnet, dass**

- vor dem Mustervergleich eine Korrektur des Profils der Wanderwelle zumindest eines Leitungsendes durchgeführt wird, bei der eine Dämpfung der Leitung (11) berücksichtigt wird.

**6.** Verfahren nach einem der vorangehenden Ansprüche,
**dadurch gekennzeichnet, dass**

- der Fehlerort (F) ausschließlich unter Verwendung solcher Strom- und Spannungswerte bestimmt wird, die an den beiden Leitungsenden während des Auftretens eines ersten Wellenimpulses einer Wanderwelle gemessen worden sind.

**7.** Verfahren nach einem der Ansprüche 1-5,
**dadurch gekennzeichnet, dass**

- der Fehlerort (F) ausschließlich unter Verwendung entweder solcher Stromwerte oder solcher Spannungswerte bestimmt wird, die an den beiden Leitungsenden während des Auftretens eines ersten Wellenimpulses einer Wanderwelle gemessen worden sind.

**8.** Verfahren nach einem der vorangehenden Ansprüche,
**dadurch gekennzeichnet, dass**

- die an den Leitungsenden (11a, 11b) gemessenen Strom- und Spannungswerte einer Filterung unterzogen werden, wobei erste und zweite gefilterte Strom- und Spannungswerte gebildet werden, die einen ausgewählten Frequenzbereich der gemessenen Strom- und Spannungswerte angeben; und
- die Profile der Wanderwellen unter Verwendung der ersten und zweiten gefilterten Strom- und Spannungswerte bestimmt werden.

**9.** Verfahren nach Anspruch 8,
**dadurch gekennzeichnet, dass**

- der ausgewählte Frequenzbereich hochfrequente transiente Anteile oder bandbegrenzte transiente Anteile der gemessenen Strom- und Spannungswerte umfasst.

**10.** Verfahren nach einem der Ansprüche 8 oder 9,
**dadurch gekennzeichnet, dass**

- die Filtercharakteristik des zur Filterung der Strom- und Spannungswerte benutzten Filters solche Frequenzbereiche bedämpft, in denen zur Messung der Strom- und Spannungsmesswerte verwendete Strom- bzw. Spannungswandler Messfehler aufweisen.

**11.** Verfahren nach einem der Ansprüche 8 bis 10,
**dadurch gekennzeichnet, dass**

- bei einem mehrphasigen elektrischen Energieversorgungsnetz hinsichtlich der ersten und zweiten gefilterten Strom- und Spannungswerte eine mathematische Transformation zur Entkopplung der einzelnen Phasenanteile durchgeführt wird, wobei erste und zweite transformierte Strom- und Spannungswerte gebildet werden; und
- die Profile der Wanderwellen unter Verwendung der ersten und zweiten transformierten Strom- und Spannungswerte bestimmt werden.

**12.** Verfahren nach einem der vorangehenden Ansprüche,
**dadurch gekennzeichnet, dass**

- die Ermittlung des Fehlerortes (F) dann vorgenommen wird, wenn im Verlauf der der ersten Strom- und Spannungswerte oder davon abgeleiteten Werten und/oder im Verlauf der zweiten Strom- und Spannungswerte oder davon abgeleiteten Werten ein Sprung festgestellt worden ist, der eine vorgegebene Schwelle übersteigt.

**13.** Verfahren nach einem der vorangehenden Ansprüche,
**dadurch gekennzeichnet, dass**

- mittels je einer Einrichtung (15a, 15b) an jedem der Leitungsenden (11a, 11b) die Ermittlung des Fehlerortes (F) erfolgt; und
- die mit den Einrichtungen (15a, 15b) ermittelten Fehlerorte (F) von den Einrichtungen (15a, 15b) ausgegeben werden.

**14.** Verfahren nach einem der Ansprüche 1-112,
**dadurch gekennzeichnet, dass**

- die Ermittlung des Fehlerortes (F) mittels einer dazu eingerichteten Einrichtung (15a, 15b) erfolgt; und
- der ermittelte Fehlerort (F) von der Einrichtung (15a, 15b) ausgegeben wird.

**15.** Einrichtung (15a, 15b) zum Ermitteln des Fehlerortes (F) eines Fehlers auf einer Leitung (11) eines elektrischen Energieversorgungsnetzes, mit

- einer Recheneinrichtung, die dazu eingerichtet ist, unter Verwendung von an einem ersten Leitungsende (11a) der Leitung (11) gemessenen und zeitgestempelten ersten Strom- und/oder Spannungswerten und an einem zweiten Leitungsende (11b) der Leitung (11) gemessenen und zeitgestempelten zweiten Strom- und/oder Spannungswerten nach dem Auftreten eines Fehlers auf der Leitung dessen Fehlerort (F) zu bestimmen;

**dadurch gekennzeichnet, dass**

- die Recheneinrichtung dazu eingerichtet ist, unter Verwendung der zeitgestempelten ersten und zweiten Strom- und/oder Spannungswerte an beiden Leitungsenden Profile von beim Auftreten des Fehlers sich entlang der Leitung in Richtung der Leitungsenden ausbreitenden Wanderwellen zu ermitteln; und
- die Recheneinrichtung dazu eingerichtet ist, den Fehlerort (F) aus den für beide Leitungsenden ermittelten Profilen der Wanderwellen zu bestimmen, indem eine Zeitdifferenz bestimmt wird, mit der die Wanderwellen an den beiden Leitungsenden eintreffen, wobei die Zeitdifferenz aus einem Mustervergleich der für die Leitungsenden ermittelten Profile der Wanderwellen bestimmt wird.

**16.** System (10) zum Ermitteln des Fehlerortes (F) eines Fehlers auf einer Leitung (11) eines elektrischen Energieversorgungsnetzes, mit zwei nach Anspruch 15 ausgebildeten Einrichtungen (15a, 15b), die mit einer Kommunikationsverbindung (16) zum Datenaustausch miteinander in Verbindung stehen und zur Durchführung eines Verfahrens gemäß einem der Ansprüche 1 bis 14 ausgebildet sind.

**Claims**

**1.** Method for determining the fault location (F) of a fault on a line (11) of an electrical energy supply network, in which

- first current and/or voltage values are measured and provided with a timestamp at a first line end (11a) of the line (11);
- second current and/or voltage values are measured and provided with a timestamp at a second line end (11b) of the line (11); and
- the fault location (F) of said fault is defined using the timestamped first and second current and/or voltage values following the occurrence of a fault on the line (11); **characterized in that**
- profiles of travelling waves propagating along the line in the direction of the line ends (11a, 11b) when the fault occurs are determined using the timestamped first and second current and/or voltage values at both line ends (11a, 11b); and
- the fault location (F) is defined from the profiles of the travelling waves determined for both line ends (11a, 11b) by defining a time difference with which the travelling waves arrive at the two line ends, wherein the time difference is defined from a pattern comparison of the profiles of the travelling waves determined for the line ends (11a, 11b).

2. Method according to Claim 1, **characterized in that**

   - a cross-correlation of the profiles is carried out for the pattern comparison of the profiles of the travelling waves.

3. Method according to Claim 1 or 2, **characterized in that**

   - an angle of the cross-power spectrum of the profiles of the travelling waves is used for the pattern comparison.

4. Method according to Claim 1, **characterized in that**

   - a minimization of a target function formed from the difference of the profiles of the travelling waves is carried out for the pattern comparison.

5. Method according to one of the preceding claims, **characterized in that**

   - before the pattern comparison, a correction of the profile of the travelling wave of at least one line end is carried out in which attenuation of the line (11) is taken into account.

6. Method according to one of the preceding claims, **characterized in that**

   - the fault location (F) is defined exclusively using current and voltage values which have been measured at the two line ends during the occurrence of a first wave pulse of a travelling wave.

7. Method according to one of Claims 1-5, **characterized in that**

   - the fault location (F) is defined exclusively using either the current values or the voltage values which have been measured at the two line ends during the occurrence of a first wave pulse of a travelling wave.

8. Method according to one of the preceding claims, **characterized in that**

   - the current and voltage values measured at the line ends (11a, 11b) are subjected to a filtering, wherein first and second filtered current and voltage values are formed which indicate a selected frequency range of the measured current and voltage values; and
   - the profiles of the travelling waves are defined using the first and second filtered current and voltage values.

9. Method according to Claim 8, **characterized in that**

   - the selected frequency range comprises high-frequency transient components or band-limited transient components of the measured current and voltage values.

10. Method according to one of Claims 8 or 9, **characterized in that**

    - the filter characteristic of the filter used to filter the current and voltage values dampens the frequency ranges in which current and voltage transformers used to measure the current and voltage measured values have measurement errors.

11. Method according to one of Claims 8 to 10, **characterized in that**

- in the case of a multiphase electrical energy supply network, in respect of the first and second filtered current and voltage values, a mathematical transformation is performed to decouple the individual phase components, wherein first and second transformed current and voltage values are formed; and
- the profiles of the travelling waves are defined using the first and second transformed current and voltage values.

**12.** Method according to one of the preceding claims, **characterized in that**

- the determination of the fault location (F) is carried out if a jump which exceeds a predefined threshold has been identified in the characteristic of the first current and voltage values or values derived therefrom and/or in the characteristic of the second current and voltage values or values derived therefrom.

**13.** Method according to one of the preceding claims, **characterized in that**

- the fault location (F) is determined in each case by means of a device (15a, 15b) at each of the line ends (11a, 11b); and
- the fault locations (F) determined with the devices (15a, 15b) are output by the devices (15a, 15b).

**14.** Method according to one of Claims 1-12,
**characterized in that**

- the fault location (F) is determined by means of a device (15a, 15b) configured for this purpose; and
- the determined fault location (F) is output by the device (15a, 15b).

**15.** Device (15a, 15b) for determining the fault location (F) of a fault on a line (11) of an electrical energy supply network, with

- a processing device which is configured to define the fault location (F) of said fault using first current and/or voltage values measured and timestamped at a first line end (11a) of the line (11) and second current and/or voltage values measured and timestamped at a second line end (11b) of the line (11) following the occurrence of a fault on the line;
**characterized in that**
- the processing device is configured to determine profiles of travelling waves propagating along the line in the direction of the line ends when the fault occurs using the timestamped first and second current and/or voltage values at both line ends; and
- the processing device is configured to define the fault location (F) from the profiles of the travelling waves determined for both line ends by defining a time difference with which the travelling waves arrive at the two line ends, wherein the time difference is defined from a pattern comparison of the profiles of the travelling waves determined for the line ends.

**16.** System (10) for determining the fault location (F) of a fault on a line (11) of an electrical energy supply network, with two devices (15a, 15b) designed according to Claim 15 which are interconnected via a communication connection (16) to exchange data and are designed to carry out a method according to one of Claims 1 to 14.

**Revendications**

**1.** Procédé de détermination de l'emplacement (F) d'un défaut sur une ligne (11) d'un réseau d'alimentation en énergie électrique, dans lequel

- on mesure des premières valeurs de courant et/ou de tension à un premier bout (11a) de la ligne (11) et on les munit d'un horodatage ;
- on mesure des deuxièmes valeurs de courant et/ou de tension à un deuxième bout (11b) de la ligne (11) et on les munit d'un horodatage ; et
- en utilisant les premières et deuxièmes valeurs de courant et/ou de tension horodatées, on détermine après l'apparition d'un défaut sur la ligne (11) son emplacement (F) ; **caractérisé en ce que**
- en utilisant les premières et deuxièmes valeurs de courant et/ou de tension horodatées aux deux bouts (11a, 11b) de la ligne, on détermine des profils d'ondes progressives se propageant à l'apparition du défaut le long de la ligne en direction des bouts (11a, 11b) de la ligne ; et

- on détermine l'emplacement (F) du défaut à partir des profils, déterminés pour les deux bouts (11a, 11b) de la ligne, des ondes progressives, en déterminant une différence de temps avec laquelle les ondes progressives arrivent aux deux bouts de la ligne, la différence de temps étant déterminée à partir d'une comparaison de modèle des profils, déterminés pour les bouts (11a, 11b) de la ligne, des ondes progressives.

2. Procédé suivant la revendication 1,
**caractérisé en ce que**,

- pour la comparaison des modèles des profils des ondes progressives, on effectue une corrélation croisée des profils.

3. Procédé suivant la revendication 1 ou 2,
**caractérisé en ce que**,

- pour la comparaison des modèles, on tire parti d'un angle du spectre de puissance croisée des profils des ondes progressives.

4. Procédé suivant la revendication 1,
**caractérisé en ce que**,

- pour la comparaison des modèles, on effectue une minimisation d'une fonction cible formée de la différence des profils des ondes progressives.

5. Procédé suivant l'une des revendications précédentes, **caractérisé en ce que**,

- avant la comparaison des modèles, on effectue une correction du profil de l'onde progressive d'au moins un bout de la ligne, dans laquelle on prend en compte un amortissement de la ligne (11).

6. Procédé suivant l'une des revendications précédentes, **caractérisé en ce que**

- on détermine l'emplacement (F) du défaut en utilisant exclusivement les valeurs de courant et de tension, qui ont été mesurées aux deux bouts de la ligne pendant l'apparition d'une première impulsion d'une onde progressive.

7. Procédé suivant l'une des revendications 1 à 5,
**caractérisé en ce que**

- on détermine l'emplacement (F) du défaut en utilisant exclusivement soit des valeurs de courant, soit des valeurs de tension, qui ont été mesurées aux deux bouts de la ligne pendant l'apparition d'une première impulsion d'une onde progressive.

8. Procédé suivant l'une des revendications précédentes,
**caractérisé en ce que**

- on soumet les valeurs de courant et de tension mesurées aux bouts (11a, 11b) de la ligne à un filtrage, des premières et deuxièmes valeurs filtrées de courant et de tension étant formées, qui donnent une plage de fréquence sélectionnée des valeurs de courant et de tension mesurées ; et
- on détermine les profils des ondes progressives en utilisant les premières et deuxièmes valeurs filtrées de courant et de tension.

9. Procédé suivant la revendication 8,
**caractérisé en ce que**

- la plage de fréquence sélectionnée comprend des parties transitoires de haute fréquence ou des parties transitoires dans une bande limitée des valeurs mesurées de courant et de tension.

10. Procédé suivant l'une des revendications 8 ou 9,
**caractérisé en ce que**,

- la caractéristique de filtre du filtre utilisé pour filtrer les valeurs de courant et de tension atténue des plages de fréquence, dans lesquelles des transducteurs de courant ou de tension, utilisés pour la mesure des valeurs de mesure de courant et de tension, présentent des erreurs de mesure.

11. Procédé suivant l'une des revendications 8 à 10,
   **caractérisé en ce que**,

   - pour un réseau d'alimentation en énergie électrique polyphasé, on effectue, en ce qui concerne les premières et les deuxièmes valeurs de courant et de tension filtrées, une transformation mathématique de découplage des diverses proportions de phase, des premières et deuxièmes valeurs transformées de courant et de tension étant formées ; et
   - on détermine les profils des ondes progressives en utilisant les premières et deuxièmes valeurs transformées de courant et de tension.

12. Procédé suivant l'une des revendications précédentes,
   **caractérisé en ce que**

   - on effectue la détermination de l'emplacement (F) du défaut si on a constaté, dans la courbe des premières valeurs de courant et de tension ou des valeurs qui en sont déduites et/ou dans la courbe des deuxièmes valeurs de courant et de tension des valeurs qui en sont déduites, un saut qui dépasse un seuil donné à l'avance.

13. Procédé suivant l'une des revendications précédentes,
   **caractérisé en ce que**,

   - au moyen de respectivement un dispositif (15a, 15b) on effectue à chacun des bouts (11a, 11b) de la ligne la détermination de l'emplacement (F) du défaut ; et
   - on émet par les dispositifs (15a, 15b) les emplacements (F) de défaut déterminés par les dispositifs (15a, 15b).

14. Procédé suivant l'une des revendications 1 à 12,
   **caractérisé en ce que**

   - on effectue la détermination de l'emplacement (F) du défaut au moyen d'un dispositif (15a, 15b) conçu à cet effet ; et
   - on émet par le dispositif (15a, 15b) l'emplacement (F) du défaut qui a été déterminé.

15. Dispositif (15a, 15b) de détermination de l'emplacement (F) d'un défaut sur une ligne (11) d'un réseau d'alimentation en énergie électrique, comprenant

   - un dispositif de calcul, qui est conçu pour déterminer en utilisant des premières valeurs de courant et/ou de tension horodatées et mesurées à un premier bout (11a) de la ligne (11) et des deuxièmes valeurs de courant et/ou de tension horodatées et mesurées à un deuxième bout (11b) de la ligne (11) après l'apparition d'un défaut sur la ligne, son emplacement (F),
   **caractérisé en ce que**
   - le dispositif de calcul est conçu pour, en utilisant les premières et deuxièmes valeurs de courant et/ou de tension horodatées aux deux bouts de la ligne, déterminer des profils d'ondes progressives se propageant à l'apparition du défaut le long de la ligne en direction des bouts de la ligne ; et
   - le dispositif de calcul est conçu pour déterminer l'emplacement (F) du défaut à partir des profils, déterminés pour les deux bouts de la ligne, des ondes progressives, en déterminant une différence de temps avec laquelle les ondes progressives arrivent aux deux bouts de la ligne, la différence de temps étant déterminée à partir d'une comparaison de modèles des profils, déterminés pour les bouts de la ligne, des ondes progressives.

16. Système (10) de détermination de l'emplacement (F) d'un défaut sur une ligne (11) d'un réseau d'alimentation en énergie électrique, comprenant deux dispositifs électriques (15a, 15b) constitués suivant la revendication 15 qui sont en liaison entre eux par une liaison (16) de communication pour l'échange de données et qui sont constitués pour effectuer un procédé suivant l'une des revendications 1 à 14.

## FIG 1

## FIG 2

FIG 3

FIG 4

FIG 5

EP 3 223 026 B1

FIG 6

FIG 7

$\tau = 103\mu s$, x=60km, l-x=90km, l=150km

# FIG 8

$\tau = 103\mu s$, x=60km, l-x=90km, l=150km

EP 3 223 026 B1

# FIG 9

$\tau = 103\mu s,\ x = 60km,\ l\text{-}x = 90km,\ l = 150km$

FIG 10

$S_{1,R}^{v}$

$S_{2,R}^{v}$

$\tau=103\mu s$, x=60km, l-x=90km, l=150km

Zeit [$\mu$s]

EP 3 223 026 B1

FIG 11

EP 3 223 026 B1

# FIG 12

Kreuzleistungsspektrum

$\tau_{max} = 103\ \mu s$

Kreuzleistungsspektrum-Winkel

$\tau = 103\ \mu s \rightarrow Winkel = 0°$

EP 3 223 026 B1

# FIG 13

Kreuzkorrelation

$\tau_{max} = 103\ \mu s$

μs

Kleinste Quadrate

$\tau_{min} = 103\ \mu s$

μs

EP 3 223 026 B1

# FIG 14

EP 3 223 026 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20060012374 A1
- EP 2476002 B1
- WO 2012126526 A1
- US 4996624 A
- US 5929642 A
- US 8655609 B2